# FASCICULE DE BREVET EUROPEEN

(11) **EP 4 548 395 B1**
(45) Date de publication et mention de la délivrance du brevet: **26.08.2026**
(21) Numéro de dépôt: 23735325.5
(22) Date de dépôt: 27.06.2023
(51) Int. Cl.: H10H 29/01, H10H 29/24, H10H 29/80

(54) **DISPOSITIF OPTOÉLECTRONIQUE ET PROCÉDÉ DE FABRICATION**
OPTOELEKTRONISCHE VORRICHTUNG UND VERFAHREN ZUR HERSTELLUNG DAVON
OPTOELECTRONIC DEVICE AND METHOD FOR MANUFACTURING SAME

(30) Priorité: 28.06.2022 FR 2206464
(43) Date de publication de la demande: 07.05.2025
(73) Titulaire: Aledia, 38800 Champagnier (FR)
(72) Inventeur: DUPONT, Tiphaine, 38000 GRENOBLE (FR)
(74) Mandataire: Hautier IP
(86) Numéro de dépôt international: PCT/EP2023/067533
(87) Numéro de publication internationale: WO 2024/003085

(56) Documents cités:
- WO-A1-2018/122357
- WO-A1-2019/103568
- WO-A1-2020/201150
- WO-A1-2020/263183
- WO-A1-2022/129250
- US-A1- 2011 297 913
- US-A1- 2017 288 093
- US-A1- 2017 323 788

## Description

### DOMAINE TECHNIQUE DE L'INVENTION

La présente invention concerne le domaine des technologies pour la microélectronique et l'optoélectronique. Elle trouve pour application particulièrement avantageuse la fabrication de dispositifs optoélectroniques, notamment des pixels à base de diodes électroluminescentes (LED).

### ETAT DE LA TECHNIQUE

Un écran d'affichage auto-émissif est un exemple de dispositif optoélectronique comprenant une pluralité de pixels émettant leur propre lumière. Chaque pixel peut ainsi être formé par une ou plusieurs LEDs ou micro-LEDs.

Un pixel est typiquement formé par trois sous-pixels émettant chacun un rayonnement de couleur différente, classiquement dans le vert, le rouge et le bleu. Les sous-pixels RGB (acronyme de « Red Green Blue ») sont généralement disposés côte à côte, soit en étant directement fabriqués côte à côte, soit en étant extraits de différents wafers puis reportés côte à côte. La taille du pixel correspond ici approximativement à la somme des tailles des sous-pixels qui le constituent. Le placement ou la fabrication des sous-pixels côte à côte requiert des étapes de report ou de masquage précises.

Pour augmenter la résolution de l'écran, il est nécessaire de diminuer la taille des pixels. Un enjeu consiste à diminuer la taille des pixels en-dessous de 50 µm, voire en-dessous de 10 µm. La précision requise pour les étapes de report ou de masquage est d'autant plus grande.

Une solution permettant de diminuer la taille d'un pixel sans augmenter de façon critique la précision de fabrication requise est de superposer les différents sous-pixels constitutifs de ce pixel. Dans cette architecture, la lumière émise par le pixel du dessous traverse les pixels situés au-dessus de celui-ci.

Le document US8269229 B2 divulgue une telle solution consistant à empiler différentes LED selon la direction d'émission des LED. Un inconvénient de cette solution est que l'efficacité d'extraction de la lumière diminue significativement.

Pour pallier cette diminution, le document US8567960 B2 divulgue une solution consistant à former des guides d'ondes verticaux régulièrement distribués au travers d'un empilement de diodes laser. Cette solution ne permet pas d'augmenter significativement l'efficacité d'extraction de la lumière. Par ailleurs, cette solution nécessite des étapes supplémentaires pour former les guides d'ondes. Cette architecture est complexe et peu efficace.

Une autre solution divulguée par le document « Eu-doped GaN and InGaN monolithically stacked full-color LEDs with a wide color Gamut, Shuhei Ichikawa et al., Applied Physics Express 14, 031008 (2021) », consiste à superposer en partie seulement les différentes LED. De cette façon, les surfaces émissives des différentes LED sont étagées. Cette architecture en escalier ne permet pas de diminuer significativement la taille du pixel.

US 2011/297913 A1 divulgue un dispositif optoélectronique comprenant deux couches émettrices, chacune des couches comprenant un ensemble de nanofils.

WO 2020/201150 A1 divulgue un dispositif optoélectronique comprenant une couche émettrice avec plusieurs ensembles de nanofils étant structurellement distincts les uns des autres.

La présente invention vise à pallier au moins partiellement les inconvénients des solutions mentionnées ci-dessus.

En particulier, un objet de la présente invention est de proposer un dispositif optoélectronique comprenant au moins deux sous-pixels, permettant d'augmenter la densité de pixels d'un écran et présentant une efficacité d'extraction de lumière améliorée. Un autre objet de la présente invention est de proposer un procédé de fabrication d'un tel dispositif optoélectronique.

Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du dispositif peuvent s'appliquer *mutatis mutandis* au procédé, et réciproquement.

### RESUME DE L'INVENTION

Pour atteindre les objectifs mentionnés ci-dessus, un aspect de la présente invention concerne un dispositif optoélectronique selon la revendication 1.

Avantageusement, chacune des couches émettrices comprend un ensemble de nanofils orientés longitudinalement selon la direction z formant la partie active de la couche émettrice.

Ainsi, contrairement aux solutions connues basées sur des couches émettrices présentant des architectures planaires, les couches émettrices selon la présente invention présentent des architectures tridimensionnelles à base de nanofils. Dans les architectures planaires superposées selon l'art antérieur, la lumière émise doit traverser de nombreuses interfaces planes perpendiculaires à la direction z. La lumière reste en partie piégée par réflexion sur ces interfaces planes. Dans le cadre du développement de la présente invention, il est apparu que les architectures tridimensionnelles à base de nanofils bénéficient d'une directivité d'émission selon la direction z supérieure à celle des architectures planaires. Cela limite le piégeage de la lumière dans ou entre les différentes couches émettrices. L'efficacité d'extraction de la lumière est ainsi augmentée.

Les nanofils sont de préférence arrangés au sein d'une même couche émettrice de façon à former un cristal photonique. Cela augmente encore la directivité d'émission de la couche émettrice. L'efficacité d'extraction de la lumière est encore améliorée.

Un autre aspect de la présente invention concerne un écran émissif comprenant une pluralité de pixels formés par des dispositifs optoélectroniques selon l'invention, disposés côte à côte dans un plan transverse à la direction z, selon la revendication 10.

Un autre aspect de la présente invention concerne un procédé de fabrication d'un tel dispositif optoélectronique selon la revendication 11.

Ainsi, le procédé permet avantageusement de fabriquer séparément les différents ensembles de nanofils. Les conditions de croissance requises pour former ces différents ensembles sont ainsi mieux maîtrisées. Le report par collage des différents ensembles permet avantageusement de former des couches émettrices superposées.

La formation de chaque ensemble de nanofils peut avantageusement se faire par croissance « pleine plaque », de façon non localisée sur le substrat. Lors du report, une précision d'alignement standard entre les différents ensembles est alors parfaitement suffisante. Le report est ainsi facilité.

Au contraire, dans le cadre d'une solution connue de fabrication directe des différents ensembles côte à côte sur un même substrat, les différents ensembles sont formés par croissances successives et localisées. Une grande précision d'alignement des différents masques de croissance et/ou de protection est alors requise, en particulier pour la fabrication de micro-LEDs. La formation du deuxième ensemble peut en outre endommager le premier ensemble formé. Des solutions de protection et de gestion des hautes températures de croissance doivent être mises en œuvre, ce qui rend ce type de procédé complexe et difficilement fiable. Des formations successives d'ensembles de nanofils superposés les uns sur les autres sur un même substrat, directement et sans report, est une solution alternative qui n'est pas envisagée dans le cadre de la présente invention, pour les raisons expliquées ci-dessus.

De façon préférée, l'une au moins parmi les premières couches de contact électrique inférieure et supérieure ou les deuxièmes couches de contact électrique inférieure et supérieure est formée à partir des première et deuxième couches de collage. Cela permet de réduire le nombre de couches et/ou d'étapes de procédé. Le coût du procédé est diminué.

Le dispositif optoélectronique et le procédé selon la présente invention permettent avantageusement de former des écrans ou des micro-écrans avec une taille de pixel inférieure ou égale à 50 µm, voire inférieure ou égale à 10 µm. De tels écrans bénéficient en outre d'une forte directivité d'émission, et d'une efficacité d'extraction lumineuse améliorée. De tels écrans peuvent avantageusement être mis en œuvre dans des applications de réalité augmentée.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1 illustre schématiquement un dispositif optoélectronique selon un premier mode de réalisation de la présente invention.
La figure 2 illustre schématiquement un dispositif optoélectronique selon un deuxième mode de réalisation de la présente invention.
La figure 3 illustre schématiquement un dispositif optoélectronique selon un troisième mode de réalisation de la présente invention.
Les figures 4A et 4B illustrent schématiquement un fonctionnement électrique d'un dispositif optoélectronique selon les premier et deuxième modes de réalisation de la présente invention.
La figure 4C illustre schématiquement un fonctionnement électrique d'un dispositif optoélectronique selon le troisième mode de réalisation de la présente invention.
Les figures 5A à 5H illustrent des étapes d'un procédé de fabrication du dispositif optoélectronique illustré à la figure 1 selon un mode de réalisation de la présente invention.
Les figures 6A à 6G illustrent des étapes d'un procédé de fabrication du dispositif optoélectronique illustré à la figure 2 selon un mode de réalisation de la présente invention.
Les figures 7A à 7G illustrent des étapes d'un procédé de fabrication du dispositif optoélectronique illustré à la figure 3 selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions des différents éléments constitutifs des couches émettrices ne sont pas forcément représentatives de la réalité.

### DESCRIPTION DÉTAILLÉE DE L'INVENTION

Avant d'entamer une revue détaillée de modes de réalisation de l'invention, il est rappelé que l'invention peut notamment comprendre les caractéristiques optionnelles ci-après pouvant être utilisées en association ou alternativement :
Selon un exemple, la première couche émettrice comprend un premier ensemble de nanofils. La deuxième couche émettrice comprend un deuxième ensemble de nanofils. La troisième couche émettrice comprend un troisième ensemble de nanofils.

Selon la présente invention, les nanofils du premier ensemble de nanofils sont structurellement différents (par exemple en diamètre et/ou en pas du réseau) de ceux du deuxième ensemble de nanofils. Les nanofils du premier ensemble de nanofils sont structurellement différents (par exemple en diamètre et/ou en pas du réseau) de ceux du troisième ensemble de nanofils. Les nanofils du deuxième ensemble de nanofils sont structurellement différents (par exemple en diamètre et/ou en pas du réseau) de ceux du troisième ensemble de nanofils.

Selon un exemple, les nanofils sont arrangés au sein d'une même couche émettrice de façon à former un cristal photonique. Cela permet d'augmenter la directivité d'émission du rayonnement produit par les nanofils, selon la direction longitudinale z. L'efficacité d'extraction est ainsi améliorée.

Selon un exemple, les parties actives des couches émettrices sont disposées en escalier, de sorte que chacun des ensembles de nanofils présentent au moins une partie non couverte par les autres ensembles de nanofils, du côté d'émission du dispositif. Les parties actives sont ainsi au moins en partie non couvertes par d'autres ensembles de nanofils. L'efficacité d'extraction est ainsi améliorée. La dimension latérale du pixel formé par les différentes couches émettrices en partie superposées selon la direction verticale z reste inférieure à la dimension d'un pixel formé par des couches émettrices adjacentes selon une direction latérale.

Selon un exemple, pour chaque couche émettrice :
- la couche de contact électrique inférieure est réfléchissante à la longueur d'onde d'émission λ1, λ2 de la couche émettrice considérée, et
- la couche de contact électrique supérieure est transparente à la longueur d'onde d'émission λ1, λ2 de la couche émettrice considérée.

Les couches de contact électrique inférieures réfléchissantes permettent d'augmenter le flux de rayonnement vers la face d'émission du dispositif. L'efficacité d'extraction est ainsi améliorée.

Selon un exemple, les couches de contact électrique supérieures transparentes ne sont pas surmontées par les ensembles de nanofils.

Selon un exemple, dans le dispositif :
- la couche de contact électrique inférieure située sous toutes les parties actives du dispositif est réfléchissante aux longueurs d'onde d'émission λ1, λ2 desdites parties actives,
- les autres couches de contact électrique inférieures sont transparentes aux longueurs d'onde λ1, λ2 des parties actives situées sous lesdites autres couches de contact électrique inférieures,
- les couches de contact électrique supérieures sont transparentes aux longueurs d'onde d'émission λ1, λ2 des parties actives situées sous lesdites couches de contact électrique supérieures.

Les couches de contact électrique inférieures et supérieures transparentes permettent de superposer différentes couches émettrices tout en laissant passer les rayonnements issus de ces couches émettrices.

Selon un exemple, les couches de contact électrique inférieures sont disposées en regard d'un côté de base du dispositif.

Selon un exemple, les couches de contact électrique supérieures sont disposées en regard d'un côté d'émission du dispositif.

Selon un exemple, toutes les couches de contact électrique inférieures sont reliées entre elles. Elles peuvent être mises à un même potentiel électrique, par exemple à la masse.

Selon un exemple, deux parties actives adjacentes selon la direction z partagent une même couche de contact électrique transparente. Cela permet de réduire l'encombrement vertical, selon z, du dispositif. Cela permet également de simplifier la conception et la fabrication du dispositif.

Selon un exemple, la couche de contact électrique supérieure d'une couche émettrice correspond à la couche de contact électrique supérieure d'une autre couche émettrice située immédiatement au-dessus de ladite couche émettrice.

Selon un exemple, certaines au moins des couches de contact électrique inférieures et supérieures sont connectées par des vias traversant selon la direction z au moins un ensemble de nanofils.

Selon un exemple, la pluralité de couches émettrices comprend au moins une troisième couche émettrice comprenant une troisième partie active configurée pour émettre un troisième rayonnement selon une troisième longueur d'onde λ3, avec λ1 ≠ λ2 ≠ λ3, ladite troisième couche émettrice comprenant un troisième ensemble de nanofils orientés longitudinalement selon la direction z et formant ladite troisième partie active.

Selon un exemple, la première couche émettrice comprend un premier ensemble de nanofils configurés pour émettre le premier rayonnement selon la première longueur d'onde λ1.

Selon un exemple, la deuxième couche émettrice comprend un deuxième ensemble de nanofils configurés pour émettre le deuxième rayonnement selon la deuxième longueur d'onde λ2, avec λ1 ≠ λ2.

Selon un exemple, la troisième couche émettrice comprend un troisième ensemble de nanofils configurés pour émettre le troisième rayonnement selon la troisième longueur d'onde λ3, avec λ1 ≠ λ2 ≠ λ3.

Selon un exemple, les premier, deuxième et troisième ensembles de nanofils sont empilés selon la direction z et au moins en partie superposés en projection selon la direction z.

Selon un exemple, les couches de contact électrique supérieures définissent les dimensions latérales des LEDs ou des sous-pixels correspondants. Cela permet d'éviter de borner physiquement les ensembles de nanofils par gravure de tranchées d'isolation ou par gravure selon une structure en mésa par exemple.

Selon un exemple, les couches de contact électrique inférieures sont déposées pleine plaque. Cela simplifie le procédé de fabrication des dispositifs optoélectroniques.

Selon un exemple, les première et deuxième couches de collage comprennent respectivement des première et deuxième couches métalliques, l'assemblage des premier et deuxième ensembles de nanofils étant effectué par thermocollage desdites première et deuxième couches métalliques.

Selon un exemple, lesdites première et deuxième couches métalliques forment la première couche de contact électrique inférieure.

Selon un exemple, le procédé comprend en outre, après assemblage et retrait du premier substrat :
- une gravure d'une partie du premier ensemble de nanofils et des première et deuxième couches de collage, de façon à exposer une partie du deuxième ensemble de nanofils,
- un dépôt d'une couche d'oxyde conductrice transparente sur la partie exposée du deuxième ensemble de nanofils, de façon à former la deuxième couche de contact électrique supérieure.

Selon un exemple, le procédé comprend en outre le dépôt d'une couche d'encapsulation transparente sur la couche d'oxyde conductrice transparente au niveau de la partie exposée du deuxième ensemble de nanofils. La couche d'encapsulation permet d'intégrer le dispositif en escalier dans des puces ou systèmes compacts. Le fait qu'elle soit transparente permet de conserver une bonne efficacité lumineuse.

Selon un exemple, les première et deuxième couches de collage comprennent respectivement des première et deuxième couches diélectriques transparentes, l'assemblage des premier et deuxième ensembles de nanofils étant effectué par collage moléculaire desdites première et deuxième couches diélectriques transparentes.

Selon un exemple, les première et deuxième couches diélectriques transparentes forment une couche diélectrique intercalaire entre la première couche de contact électrique inférieure et la deuxième couche de contact électrique supérieure.

Selon un exemple, les première et deuxième couches de collage comprennent respectivement des première et deuxième couches d'oxyde conductrices transparentes, l'assemblage des premier et deuxième ensembles de nanofils étant effectué par collage moléculaire desdites première et deuxième couches d'oxyde conductrices transparentes.

Selon un exemple, les première et deuxième couches d'oxyde conductrices transparentes forment à la fois la première couche de contact électrique inférieure et la deuxième couche de contact électrique inférieure.

Sauf incompatibilité, des caractéristiques techniques décrites en détail pour un mode de réalisation donné peuvent être combinées aux caractéristiques techniques décrites dans le contexte d'autres modes de réalisation décrits à titre exemplaire et non limitatif, de manière à former un autre mode de réalisation qui n'est pas nécessairement illustré ou décrit. Un tel mode de réalisation n'est évidemment pas exclu de l'invention.

On entend par « dispositif optoélectronique » un dispositif apte à émettre, véhiculer, ou recevoir de la lumière. Selon une application particulière, un tel dispositif optoélectronique comprend des diodes électroluminescentes (LED), en particulier des LEDs formant les sous-pixels d'un pixel d'écran émissif.

L'invention peut être mise en œuvre plus largement pour différents dispositifs optoélectroniques. L'invention peut par exemple être mise en œuvre dans le cadre de dispositifs laser ou photovoltaïque.

Les LEDs ou dispositifs optoélectroniques présentent typiquement dans le cadre de la présente invention des dimensions, en projection dans un plan de base xy, inférieures à 100 µm X 100 µm, de préférence inférieures à 10 µm X 10 µm.

Sauf mention explicite, il est précisé que, dans le cadre de la présente invention, la disposition relative d'une deuxième couche intercalée entre une première couche et une troisième couche, ne signifie pas obligatoirement que les couches sont directement au contact les unes des autres, mais signifie que la deuxième couche est soit directement au contact des première et troisième couches, soit séparée de celles-ci par au moins une autre couche ou au moins un autre élément.

Ainsi, les termes et locutions « prendre appui », « surmonter », « couvrir » ou « recouvrir » ne signifient pas nécessairement « au contact de ».

Les étapes du procédé telles que revendiquées s'entendent au sens large et peuvent éventuellement être réalisées en plusieurs sous-étapes.

Dans la présente demande de brevet, les termes « diode électroluminescente », « LED » ou simplement « diode » sont employés en synonymes. Une « LED » peut également s'entendre d'une « micro-LED ».

Dans le cadre de la présente invention, les ensembles de nanofils appartiennent à des couches émettrices différentes et sont distincts les uns des autres. Ces ensembles de nanofils ne peuvent être arbitrairement définis comme des sous-parties d'un ensemble unique. Plusieurs jonctions formées dans un même nanofil ne forment pas structurellement plusieurs nanofils distincts.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, une diode à base de GaN comprend typiquement du GaN et des alliages d'AlGaN ou d'InGaN.

Un repère, de préférence orthonormé, comprenant les axes x, y, z est représenté sur certaines figures annexées. Ce repère est applicable par extension aux autres figures d'une même planche de figures.

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan de base xy. Ainsi, une couche présente typiquement une épaisseur selon z, lorsqu'elle s'étend principalement le long d'un plan xy, et un élément en saillie, par exemple un nanofil, présente une hauteur selon z. Les termes relatifs « sur », « sous », « sous-jacent » se réfèrent préférentiellement à des positions prises selon la direction z. Dans la présente demande, « vertical », « verticalement » signifient « dirigé selon la direction z » et « latéral », « latéralement » signifient « dirigé selon une direction du plan xy ».

Dans le cadre de la présente invention, un objet ou un matériau « transparent » signifie que l'objet ou le matériau laisse passer au moins 90% de l'intensité lumineuse du faisceau lumineux qui le traverse. Une surface est considérée comme « réfléchissante » dès lors qu'elle réémet au moins 85% de l'intensité d'un faisceau lumineux incident. La réflexion peut être spéculaire (une direction de réflexion), ou diffuse (plusieurs directions de réflexion).

Les valeurs dimensionnelles s'entendent aux tolérances de fabrication et de mesure près.

Les termes « sensiblement », « environ », « de l'ordre de » signifient, lorsqu'ils se rapportent à une valeur, « à 10% près » de cette valeur ou, lorsqu'ils se rapportent à une orientation angulaire, « à 10° près » de cette orientation. Ainsi, une direction sensiblement normale à un plan signifie une direction présentant un angle de 90±10° par rapport au plan.

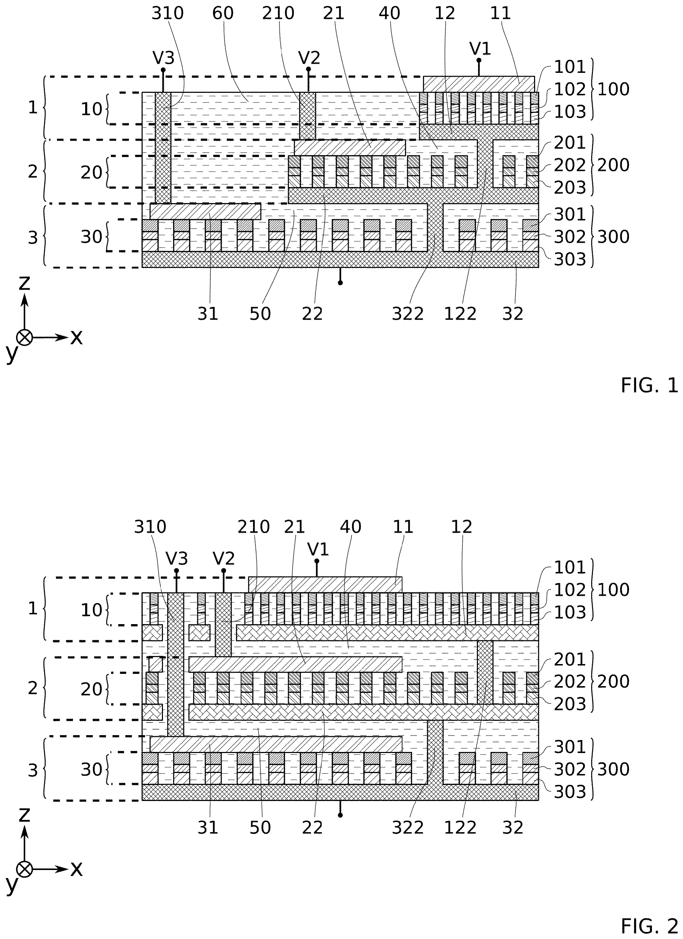

Les figures 1, 2 et 3 illustrent différents modes de réalisation d'un dispositif optoélectronique comprenant trois couches émettrices 1, 2, 3.

Chaque couche émettrice comprend typiquement un ensemble de nanofils configuré pour émettre un rayonnement lumineux à une longueur d'onde λ particulière. Chaque ensemble de nanofils comprend une pluralité de nanofils semiconducteurs de préférence principalement dirigés selon z, noyés dans une matrice à base d'un matériau diélectrique. Les nanofils semiconducteurs comprennent typiquement chacun une région active intercalée entre une région d'injection d'électrons et une région d'injection de trous. La région active émet le rayonnement lumineux de longueur d'onde λ par recombinaison radiative des électrons et des trous.

Selon une possibilité, tous les nanofils d'un ensemble de nanofils donné présentent des diamètres sensiblement identiques. Selon une possibilité, tous les nanofils d'un ensemble de nanofils donné sont séparés les uns les autres par une distance de séparation environ constante selon une direction donnée du plan xy. Les positions des nanofils d'un ensemble de nanofils donné sont de préférence distribuées selon un réseau ordonné. Les diamètres et les positions des nanofils d'un ensemble de nanofils donné sont de préférence choisis de façon à ce que l'ensemble de nanofils forme un cristal photonique. L'agencement des nanofils selon un cristal photonique permet d'optimiser l'extraction de lumière de l'ensemble de nanofils. Le rayonnement lumineux d'un tel ensemble de nanofils agencés selon un cristal photonique présente une directivité selon z augmentée.

De façon préférée, la première couche émettrice 1 comprend un premier ensemble 10 de nanofils 100 configurés pour émettre le rayonnement lumineux de longueur d'onde λ1 avec λ1 correspondant à une longueur d'onde visible sensiblement bleue. Les nanofils 100 de l'ensemble 10 comprennent typiquement chacun une région d'injection d'électrons 101, une région active 102 et une région d'injection de trous 103. Les nanofils 100 sont par exemple à base de GaN, d'AlGaN ou d'InGaN. Ces nanofils 100 sont de préférence distribués au sein de l'ensemble 10 selon un cristal photonique optimisé pour la longueur d'onde λ1. La première couche émettrice 1 comprend en outre une première couche de contact électrique supérieure 11 sur le premier ensemble 10 de nanofils 100 et une première couche de contact électrique inférieure 12 sous le premier ensemble 10 de nanofils 100. Les premières couches de contact électrique supérieure et inférieure 11, 12 connectent au moins certains nanofils 100 du premier ensemble 10, respectivement au niveau des régions d'injection d'électrons et de trous 101, 103.

De façon préférée, la deuxième couche émettrice 2 comprend un deuxième ensemble 20 de nanofils 200 configurés pour émettre le rayonnement lumineux de longueur d'onde λ2 avec λ2 ≠ λ1, et λ2 correspondant à une longueur d'onde visible sensiblement verte. Les nanofils 200 de l'ensemble 20 comprennent typiquement chacun une région d'injection d'électrons 201, une région active 202 et une région d'injection de trous 203. Les nanofils 200 sont par exemple à base de GaN, d'AlGaN ou d'InGaN. Ces nanofils 200 sont de préférence distribués au sein de l'ensemble 20 selon un cristal photonique optimisé pour la longueur d'onde λ2. La deuxième couche émettrice 2 comprend en outre une deuxième couche de contact électrique supérieure 21 sur le deuxième ensemble 20 de nanofils 200 et une deuxième couche de contact électrique inférieure 22 sous le deuxième ensemble 20 de nanofils 200. Les deuxièmes couches de contact électrique supérieure et inférieure 21, 22 connectent au moins certains nanofils 200 du deuxième ensemble 20, respectivement au niveau des régions d'injection d'électrons et de trous 201, 203.

De façon préférée, la troisième couche émettrice 3 comprend un troisième ensemble 30 de nanofils 300 configurés pour émettre le rayonnement lumineux de longueur d'onde λ3 avec λ3 ≠ λ2 ≠ λ1, et λ3 correspondant à une longueur d'onde visible sensiblement rouge. Les nanofils 300 de l'ensemble 30 comprennent typiquement chacun une région d'injection d'électrons 301, une région active 302 et une région d'injection de trous 303. Les nanofils 300 sont par exemple à base de GaN, d'AlGaN ou d'InGaN. Ces nanofils 300 sont de préférence distribués au sein de l'ensemble 30 selon un cristal photonique optimisé pour la longueur d'onde λ3. La troisième couche émettrice 3 comprend en outre une troisième couche de contact électrique supérieure 31 sur le troisième ensemble 30 de nanofils 300 et une troisième couche de contact électrique inférieure 32 sous le troisième ensemble 30 de nanofils 300. Les troisièmes couches de contact électrique supérieure et inférieure 31, 32 connectent au moins certains nanofils 300 du troisième ensemble 30, respectivement au niveau des régions d'injection d'électrons et de trous 301, 303.

Dans la suite, différents agencements de ces couches émettrices 1, 2, 3 au sein du dispositif optoélectronique sont décrits. Le dispositif électronique présente de préférence un côté d'émission, tourné vers le haut sur les figures d'accompagnement, et un côté de base opposé au côté d'émission et tourné vers le bas sur les figures d'accompagnement.

La figure 1 illustre un dispositif optoélectronique comprenant trois couches émettrices 1, 2, 3 empilées selon z et partiellement superposées. Dans ce premier mode de réalisation, les couches émettrices 1, 2, 3 sont étagées les unes par rapport aux autres, selon une configuration en escalier. Ainsi, la troisième couche émettrice 3 est surmontée par la deuxième couche émettrice 2, décalée latéralement, ce qui forme une marche, et la deuxième couche émettrice 2 est surmontée par la première couche émettrice 1, décalée latéralement, ce qui forme une autre marche. Cet étagement en escalier permet de dégager les parties actives des différentes couches émettrices 1, 2, 3, c'est-à-dire les parties qui émettent de manière effective respectivement les rayonnements de longueurs d'onde λ1, λ2, λ3. Une partie active est ainsi typiquement formée par un ou plusieurs nanofils connectés électriquement à la fois au niveau de leurs régions d'injection d'électrons et à la fois au niveau de leurs régions d'injection de trous. Dans ce premier mode de réalisation, la partie active d'une couche émettrice n'est pas surmontée par d'autres ensembles de nanofils ou d'autres parties des autres couches émettrices. Cela permet d'optimiser l'extraction lumineuse du dispositif, notamment du côté d'émission du dispositif.

Dans ce premier mode de réalisation, les couches de contact électrique inférieures 12, 22, 32 s'étendent de préférence respectivement sous tous les nanofils 100, 200, 300 de chacun des ensembles 10, 20, 30. Les couches de contact électrique inférieures 12, 22, 32 sont typiquement métalliques et forment des réflecteurs pour les rayonnements de longueur d'onde λ1, λ2, λ3. Un rayonnement émis en direction du côté de base est ainsi avantageusement réfléchi en direction du côté d'émission du dispositif. Cela permet d'optimiser l'extraction lumineuse du côté d'émission du dispositif.

Dans ce premier mode de réalisation, les couches de contact électrique supérieures 11, 21, 31 s'étendent de préférence respectivement sur une partie seulement des nanofils 100, 200, 300 de chacun des ensembles 10, 20, 30. En particulier, la couche de contact électrique supérieure 31 s'étend sur les nanofils 300 qui ne sont pas surmontés par des nanofils 200 et par des nanofils 100. La couche de contact électrique supérieure 21 s'étend sur les nanofils 200 qui ne sont pas surmontés par des nanofils 100. Les couches de contact électrique supérieures 11, 21, 31 sont typiquement à base d'oxyde conducteur transparent, par exemple à base d'ITO (Indium Tin Oxyde). Elles sont transparentes au moins respectivement pour les rayonnements de longueur d'onde λ1, λ2, λ3. Les couches de contact électrique supérieures 11, 21, 31 définissent sensiblement les parties actives respectives des couches émettrices 1, 2, 3.

Dans ce premier mode de réalisation, les couches de contact électrique inférieures 12, 22, 32 sont de préférence reliées entre elles par des vias 122, 322. Elles peuvent ainsi être mises à un même potentiel électrique. La première couche de contact électrique inférieure 12 est reliée à la deuxième couche de contact électrique inférieure 22 par un ou plusieurs vias 122. La deuxième couche de contact électrique inférieure 22 est reliée à la troisième couche de contact électrique inférieure 32 par un ou plusieurs vias 322. La première couche de contact électrique inférieure 12 est séparée du deuxième ensemble 20 de nanofils 200 par une couche diélectrique intercalaire 40. La deuxième couche de contact électrique inférieure 22 est séparée du troisième ensemble 30 de nanofils 300 par une couche diélectrique intercalaire 50.

Dans ce premier mode de réalisation, les parties actives dégagées formant des marches peuvent être recouvertes par une couche d'encapsulation 60 transparente aux longueurs d'onde λ1, λ2 et/ou λ3. Cela permet d'obtenir un dispositif présentant une surface sensiblement plane et horizontale, qui peut être facilement intégré au sein d'une puce ou d'un système électronique. Des vias 210, 310 peuvent traverser cette couche d'encapsulation 60 pour venir connecter respectivement les couches de contact électrique supérieures 21, 31. Dans ce premier mode de réalisation, toutes les régions d'injection d'électrons 101, 201, 301 sont de préférence disposées d'un même côté, par exemple du côté d'émission du dispositif comme illustré à la figure 1. Les LED formées par les couches émettrices 1, 2, 3 présentent ainsi toutes un même sens passant pour le courant.

La figure 2 illustre un deuxième mode de réalisation du dispositif optoélectronique. Dans ce deuxième mode de réalisation, les couches émettrices 1, 2, 3 sont superposées selon z. Ainsi, l'encombrement latéral du dispositif est diminué. Dans le cas de couches émettrices correspondant à des sous-pixels, la dimension latérale du pixel comprenant les sous-pixels diminue, et la résolution de l'écran peut être augmentée. Dans ce deuxième mode de réalisation, les parties actives des couches émettrices sont superposées les unes aux autres. Cela permet d'obtenir un mélange de couleur natif pour un pixel présentant une telle architecture. Les effets de cristaux photoniques sont en outre renforcés par les nanofils adjacents latéralement aux différentes parties actives.

De façon préférée, la couche émettrice 3 émettant dans le rouge est surmontée par la couche émettrice 2 émettant dans le vert, et la couche émettrice 2 émettant dans le vert est surmontée par la couche émettrice 1 émettant dans le bleu, en direction du côté d'émission du dispositif. Cela permet de minimiser les interactions optiques entre les différents rayonnements lumineux lors de leur propagation vers le côté d'émission du dispositif.

Dans ce deuxième mode de réalisation, les couches de contact électrique inférieures 12, 22, 32 s'étendent de préférence respectivement sous tous les nanofils 100, 200, 300 de chacun des ensembles 10, 20, 30. La couche de contact électrique inférieure 32 disposée du côté de base du dispositif est typiquement métallique et forme un réflecteur pour les rayonnements de longueur d'onde λ1, λ2, λ3. Un rayonnement émis en direction du côté de base est ainsi avantageusement réfléchi en direction du côté d'émission du dispositif. Cela permet d'optimiser l'extraction lumineuse du côté d'émission du dispositif. Les couches de contact électrique inférieures 12, 22 sont typiquement à base d'oxyde conducteur transparent. Cela permet de laisser passer le rayonnement émis par la couche émettrice sous-jacente, en direction du côté d'émission du dispositif.

Dans ce deuxième mode de réalisation, les couches de contact électrique supérieures 11, 21, 31 s'étendent de préférence respectivement sur une partie seulement des nanofils 100, 200, 300 de chacun des ensembles 10, 20, 30. Les couches de contact électrique supérieures 11, 21, 31 sont typiquement à base d'oxyde conducteur transparent, par exemple à base d'ITO (Indium Tin Oxyde). Elles sont transparentes pour les rayonnements de longueur d'onde λ1, λ2, λ3. Les couches de contact électrique supérieures 11, 21, 31 définissent sensiblement les parties actives respectives des couches émettrices 1, 2, 3, et donc les dimensions latérales des sous-pixels correspondants.

Dans ce deuxième mode de réalisation, des vias 210, 310 peuvent traverser les premier et deuxième ensembles 10, 20 de nanofils 100, 200 pour venir connecter respectivement les couches de contact électrique supérieures 21, 31. Les couches de contact électrique inférieures 12, 22, 32 sont de préférence reliées entre elles par des vias 122, 322. La première couche de contact électrique inférieure 12 est séparée de la deuxième couche de contact électrique supérieure 21 par une couche diélectrique intercalaire 40. La deuxième couche de contact électrique inférieure 22 est séparée de la troisième couche de contact électrique supérieure 31 par une couche diélectrique intercalaire 50.

Dans ce deuxième mode de réalisation, toutes les régions d'injection d'électrons 101, 201, 301 sont de préférence disposées d'un même côté, par exemple du côté d'émission du dispositif comme illustré à la figure 2. Les LED formées par les couches émettrices 1, 2, 3 présentent ainsi toutes un même sens passant pour le courant.

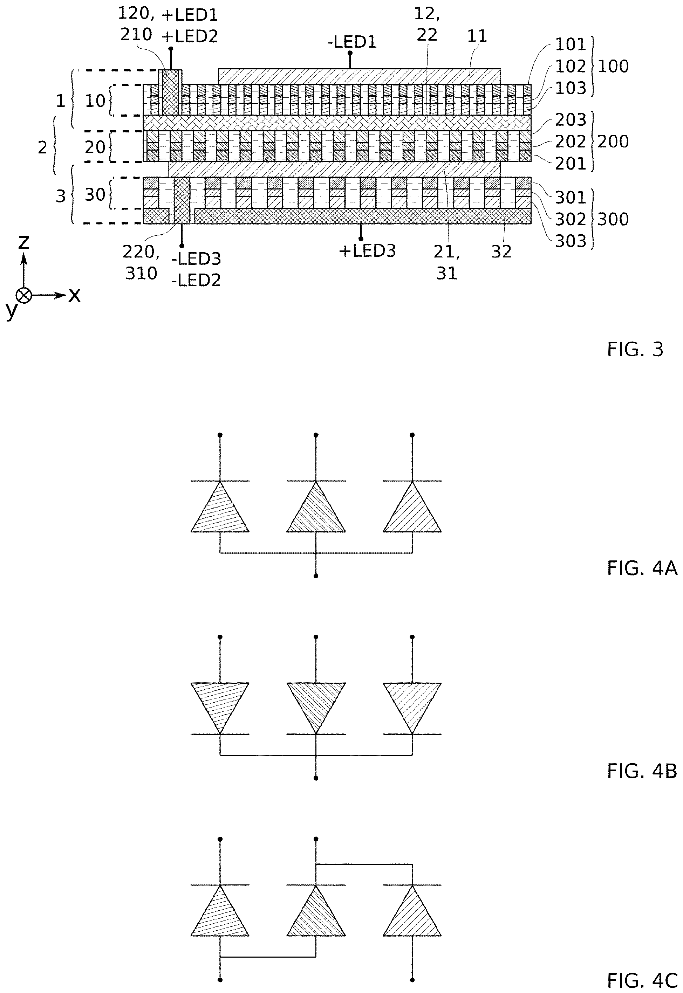

La figure 3 illustre un troisième mode de réalisation du dispositif optoélectronique. Dans ce troisième mode de réalisation, les couches émettrices 1, 2, 3 sont superposées selon z et partagent au moins une couche de contact électrique inférieure et/ou supérieure avec la ou les couches émettrices adjacentes. Cela permet de réduire l'encombrement vertical du dispositif. Cela permet également de simplifier la conception du dispositif et de réduire les coûts de fabrication du dispositif. Comme pour le deuxième mode de réalisation, cette architecture permet d'obtenir un mélange de couleur natif pour le pixel. Les effets de cristaux photoniques sont en outre renforcés. Les couches émettrices sont de préférence empilées depuis le côté de base du dispositif jusqu'au côté d'émission du dispositif, selon les longueurs d'onde d'émission respectives rouge, vert, bleu.

Dans ce troisième mode de réalisation, les couches de contact électrique inférieures 12, 22, 32 s'étendent de préférence respectivement sur ou sous tous les nanofils 100, 200, 300 de chacun des ensembles 10, 20, 30. La couche de contact électrique inférieure 32 disposée du côté de base du dispositif est typiquement métallique et forme un réflecteur pour les rayonnements de longueur d'onde λ1, λ2, λ3. Un rayonnement émis en direction du côté de base est ainsi avantageusement réfléchi en direction du côté d'émission du dispositif. Les couches de contact électrique supérieures 11, 21, 31 s'étendent de préférence respectivement sur une partie seulement des nanofils 100, 200, 300 de chacun des ensembles 10, 20, 30. Elles sont transparentes pour les rayonnements de longueur d'onde λ1, λ2, λ3.

Dans ce troisième mode de réalisation, les couches de contact électrique inférieures 12, 22 forment typiquement une seule et même couche à base d'oxyde conducteur transparent. Les couches de contact électrique supérieures 21, 31 forment typiquement une seule et même couche à base d'oxyde conducteur transparent, par exemple à base d'ITO (Indium Tin Oxyde). Dans ce troisième mode de réalisation, il n'y a pas de couches intercalaires diélectriques entre les couches de contact électrique 12, 22 d'une part et entre les couches de contact électrique 21, 31 d'autre part.

Dans ce troisième mode de réalisation, les régions d'injection d'électrons 101, 301 des premier et troisième ensembles 10, 30 de nanofils 100, 300 sont de préférence disposées d'un même côté, par exemple du côté d'émission du dispositif comme illustré à la figure 3. Les régions d'injection d'électrons 201 du deuxième ensemble 20 de nanofils 200 sont de préférence disposées du côté opposé, par exemple du côté de base du dispositif comme illustré à la figure 3. Dans ce mode de réalisation, les LED formées par les couches émettrices 1, 2, 3 ne présentent pas toutes le même sens passant pour le courant.

Dans ce troisième mode de réalisation, des vias 120, 210 peuvent traverser le premier ensemble 10 de nanofils 100 pour venir connecter les couches de contact électrique inférieures 12, 22. Les couches de contact électrique inférieures 12, 22 peuvent ainsi être mises au même potentiel électrique. Des vias 220, 310 peuvent traverser le troisième ensemble 30 de nanofils 300 pour venir connecter les couches de contact électrique supérieures 21, 31. Les couches de contact électrique supérieures 21, 31 peuvent ainsi être mises au même potentiel électrique.

Les figures 4A, 4B, 4C illustrent les différentes configurations électriques permises par les dispositifs selon les différents modes de réalisation décrits ci-dessus. Les figures 4A, 4B illustrent deux configurations de diodes électroluminescentes en parallèle, avec un contact commun, qui peuvent être réalisées à partir des premier et deuxième modes de réalisation du dispositif décrits ci-dessus. La figure 4C illustre une configuration de diodes électroluminescentes avec des sens passant en alternance, qui peut être réalisée à partir du troisième mode de réalisation du dispositif décrit ci-dessus. Dans ce cas, les LED sont typiquement activées successivement les unes aux autres. Un rapport cyclique de fonctionnement ou d'allumage peut être défini pour les différentes LED d'un pixel présentant cette architecture.

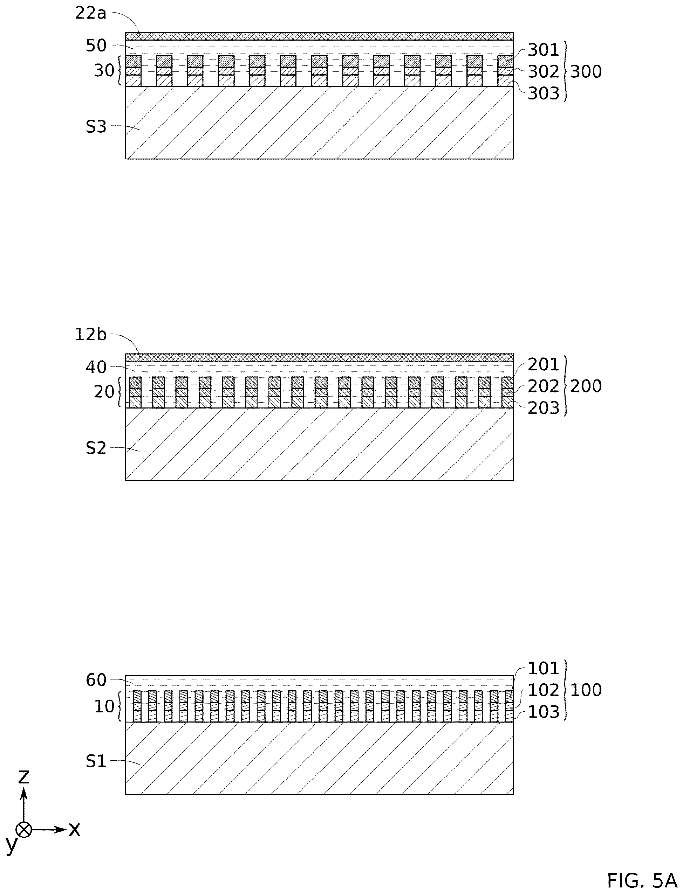

Les figures 5A à 5H illustrent des étapes de fabrication d'un dispositif optoélectronique tel qu'illustré en figure 1.

Comme illustré à la figure 5A, la première étape consiste à former séparément les différents ensembles 10, 20, 30 de nanofils sur des substrats S1, S2, S3 distincts. De façon connue, les substrats S1, S2, S3 peuvent typiquement comprendre chacun un support par exemple en silicium, une couche tampon à base de GaN, une couche de nucléation à base d'AIN et/ou une couche de masquage à base d'un matériau diélectrique, par exemple en nitrure de silicium Si3N4. La couche de masquage permet notamment de faire croître les nanofils de façon localisée sur le substrat, selon un procédé appelé SAG (acronyme de « Selective Area Growth »), de préférence selon un réseau ordonné afin de former un cristal photonique.

Les nanofils 100, 200, 300 sont de préférence épitaxiés respectivement sur les substrats S1, S2, S3, par exemple par épitaxie en phase vapeur à précurseurs organométalliques MOVPE (acronyme de « MetalOrganic Vapour Phase Epitaxy ») ou par épitaxie par jets moléculaires MBE (acronyme anglais de « Molecular Beam Epitaxy »).

Les nanofils 100, 200, 300 sont à base d'un matériau semiconducteur, de préférence à base de matériaux III-V, par exemple à base de GaN, d'AlGaN, d'InGaN. Ils peuvent être alternativement à base de matériaux II-VI, par exemple à base de ZnO, ZnSe, ou encore à base de matériaux IV-IV, par exemple à base de Si, de SiGe.

Les nanofils 100, 200, 300 s'étendent de préférence longitudinalement selon z. Ils peuvent présenter une hauteur comprise entre quelques dizaines de nanomètres et plusieurs micromètres, par exemple entre 100 nm et 20 µm. Ils peuvent présenter différentes formes, en section dans le plan xy. Les nanofils 100, 200, 300 à base de GaN présentent typiquement une section sensiblement hexagonale. La dimension maximale des nanofils dans le plan xy, par exemple le diamètre, peut être comprise entre quelques dizaines de nanomètres et plusieurs micromètres, par exemple entre 50 nm et 5 µm. Ils sont de préférence sensiblement parallèles entre eux et régulièrement distribués sur les substrats S1, S2, S3. Ils peuvent être encapsulés dans une matrice à base d'un matériau diélectrique tel que du dioxyde de silicium ou du nitrure de silicium. Cela permet de protéger les nanofils 100, 200, 300. Cela permet également d'améliorer la tenue mécanique des réseaux de nanofils 100, 200, 300 sur leurs substrats respectifs S1, S2, S3. Les nanofils sont ici de préférence formés avec les régions d'injection de trous 103, 203, 303 du côté des substrats S1, S2, S3.

Après croissance et encapsulation des nanofils 100, 200, 300, une étape de planarisation, par exemple par polissage mécano-chimique CMP (acronyme de « Chemical Mechanical Polishing »), est typiquement effectuée de façon à obtenir une surface plane affleurant le sommet des régions d'injection d'électrons 101, 201, 301.

Des couches intercalaires diélectriques 40, 50, 60 sont ensuite formées sur les surfaces planarisées des ensembles 10, 20, 30 de nanofils 100, 200, 300, par exemple par dépôt chimique en phase vapeur CVD (acronyme de « Chemical Vapor Deposition »). Les couches intercalaires diélectriques 40, 50 sont ensuite recouvertes par des couches de collage 12b, 22a métalliques, typiquement par un procédé de dépôt pleine plaque. Les couches de collage 12b, 22a métalliques peuvent être à base d'aluminium, d'argent et/ou d'or.

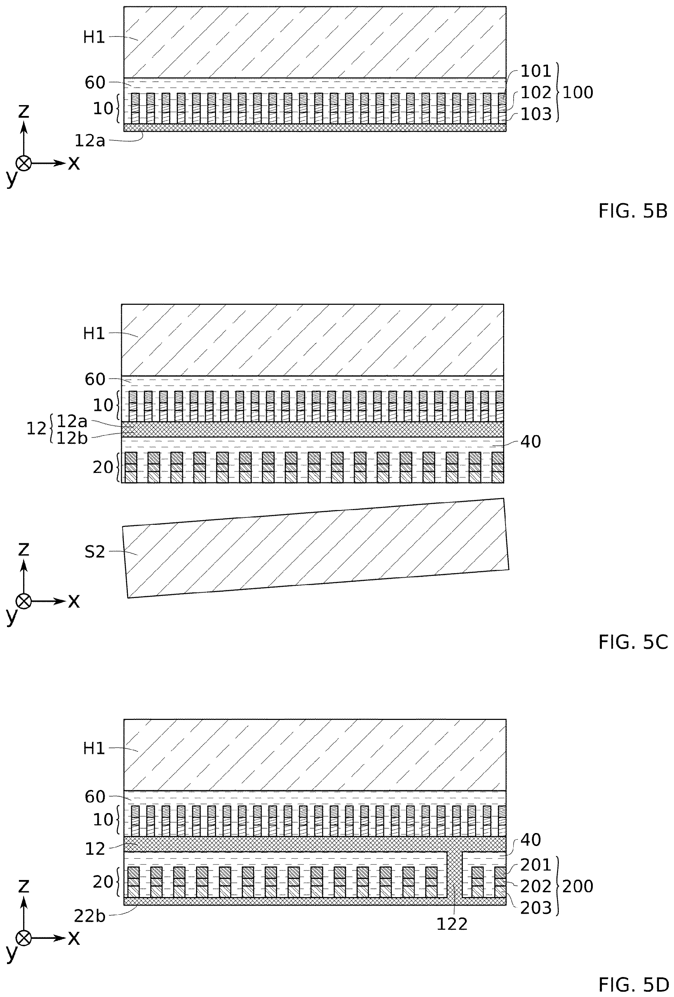

Comme illustré à la figure 5B, un substrat de manipulation H1 est assemblé par collage à l'ensemble 10 de nanofils 100, par l'intermédiaire de la couche intercalaire diélectrique 60. Le substrat S1 est ensuite retiré et une couche de collage 12a métallique est formée au niveau des régions d'injection de trous 103, de préférence pleine plaque.

Comme illustré à la figure 5C, les ensembles 10, 20 de nanofils 100, 200 sont ensuite assemblés par collage métal-métal entre les couches de collage 12a, 12b, par exemple par thermocompression Au-Au pour des couches de collage 12b, 12a à base d'or. Les couches de collage 12a, 12b déposées pleine plaque permettent une tolérance d'alignement entre les ensembles 10, 20 de nanofils 100, 200. Les couches de collage 12a, 12b forment avantageusement la première couche de contact électrique inférieure 12. Le substrat S2 est ensuite retiré.

Comme illustré à la figure 5D, une couche de collage 22b métallique est formée au niveau des régions d'injection de trous 203, de préférence pleine plaque. Un ou des vias 122 peuvent être formés au travers de l'ensemble 20 de nanofils 200 de manière à connecter électriquement la couche de collage 22b à la première couche de contact électrique inférieure 12.

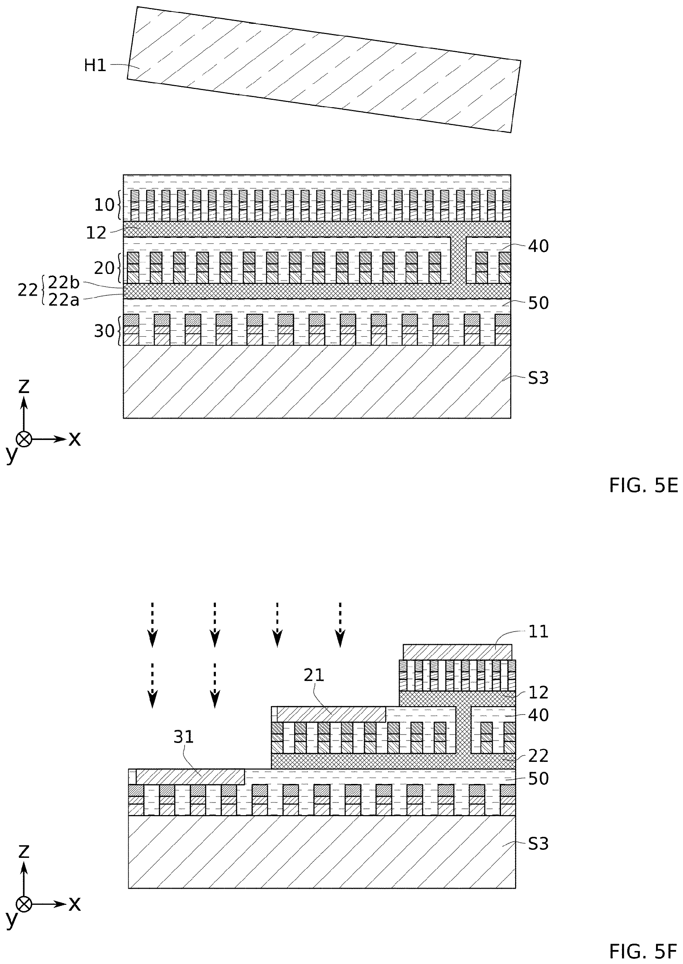

Comme illustré à la figure 5E, les ensembles 20, 30 de nanofils 200, 300 sont ensuite assemblés par collage métal-métal entre les couches de collage 22a, 22b, par exemple par thermocompression Au-Au pour des couches de collage 22b, 22a à base d'or. Les couches de collage 22a, 22b déposées pleine plaque permettent une tolérance d'alignement entre les ensembles 20, 30 de nanofils 200, 300. Les couches de collage 22a, 22b forment avantageusement la deuxième couche de contact électrique inférieure 22. Le substrat de manipulation H1 est ensuite retiré.

Comme illustré à la figure 5F, une première gravure ou série de gravures localisée est effectuée de façon à exposer une partie de l'ensemble 20 de nanofils 200. Une deuxième gravure ou série de gravures localisée est ensuite effectuée de façon à exposer une partie de l'ensemble 30 de nanofils 300. Ces gravures successives sont configurées de façon à obtenir une structure en escaliers des ensembles 30, 20, 10 de nanofils 300, 200, 100. Après gravures, les couches de contact électrique supérieures 11, 21, 31 à base d'oxyde conducteur transparent sont formées sur les parties exposées des ensembles 10, 20, 30 de nanofils 100, 200, 300.

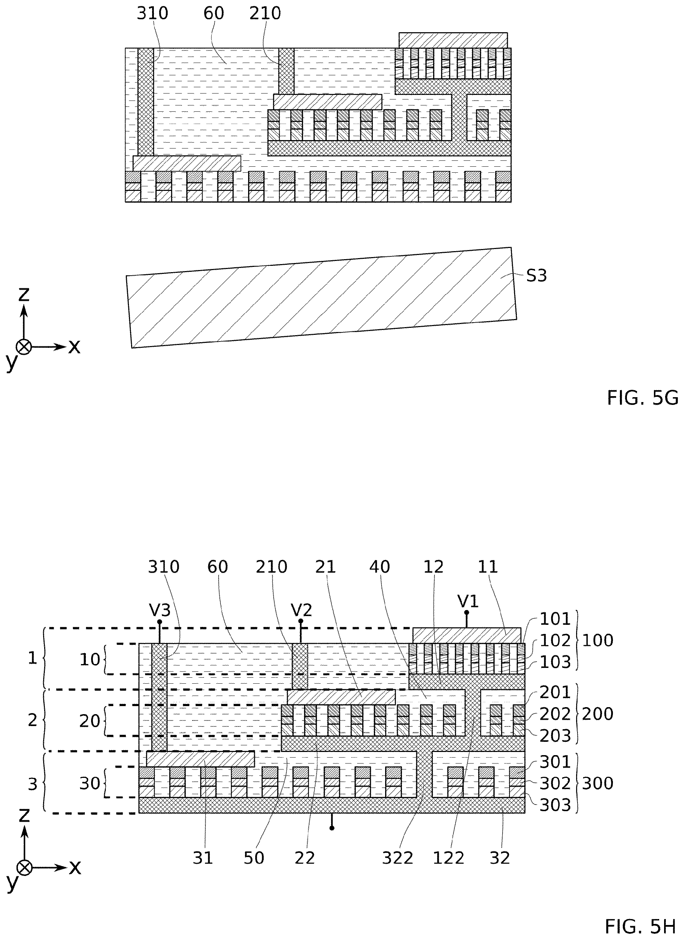

Comme illustré à la figure 5G, la structure en escaliers peut être encapsulée par une couche d'encapsulation 60 transparente puis planarisée. Des vias 210, 310 peuvent être formés au travers de cette couche d'encapsulation 60 pour connecter électriquement les couches de contact électrique supérieures 21, 31. Le substrat S3 peut ensuite être retiré ou aminci.

Comme illustré à la figure 5H, après retrait du substrat S3, la troisième couche de contact électrique inférieure 32 métallique peut être formée au niveau des régions d'injection de trous 303. Selon une possibilité non illustrée, le substrat S3 est électriquement conducteur et n'est pas retiré en totalité. Il est aminci pour former directement la troisième couche de contact électrique inférieure 32. Un ou des vias 322 peuvent ensuite être formés au travers de l'ensemble 30 de nanofils 300 de manière à connecter électriquement la troisième couche de contact électrique inférieure 32 à la deuxième couche de contact électrique inférieure 22.

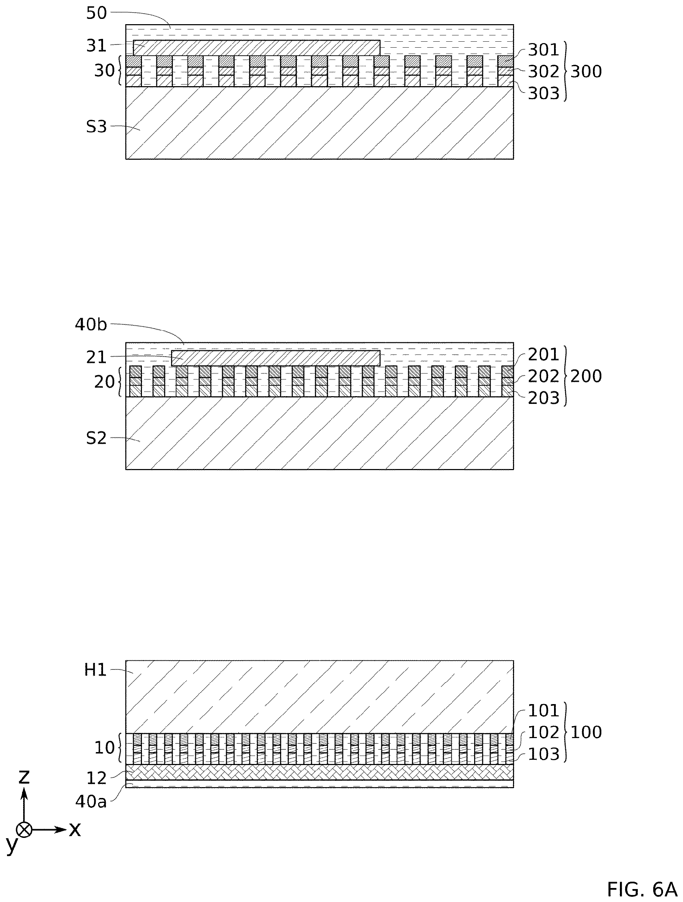

Les figures 6A à 6G illustrent des étapes de fabrication d'un dispositif optoélectronique tel qu'illustré en figure 2, selon un autre mode de réalisation de l'invention.

Comme illustré à la figure 6A, la première étape consiste à former séparément les différents ensembles 10, 20, 30 de nanofils sur des substrats S1, S2, S3 distincts. Comme précédemment, un substrat de manipulation H1 est assemblé à l'ensemble 10 de nanofils 100 et le substrat S1 est retiré.

Les couches de contact électrique supérieures 21, 31 à base d'oxyde conducteur transparent sont formées sur les surfaces planarisées des ensembles 20, 30 de nanofils 200, 300, puis recouvertes par des couches de collage 40b, 50 typiquement à base d'un matériau diélectrique tel que l'oxyde de silicium. La première couche de contact électrique inférieure 12 à base d'oxyde conducteur transparent est formée de préférence pleine plaque au niveau des régions d'injection de trous 103, et une couche de collage 40a similaire aux couches de collage 40b, 50 est formée sur la première couche de contact électrique inférieure 12.

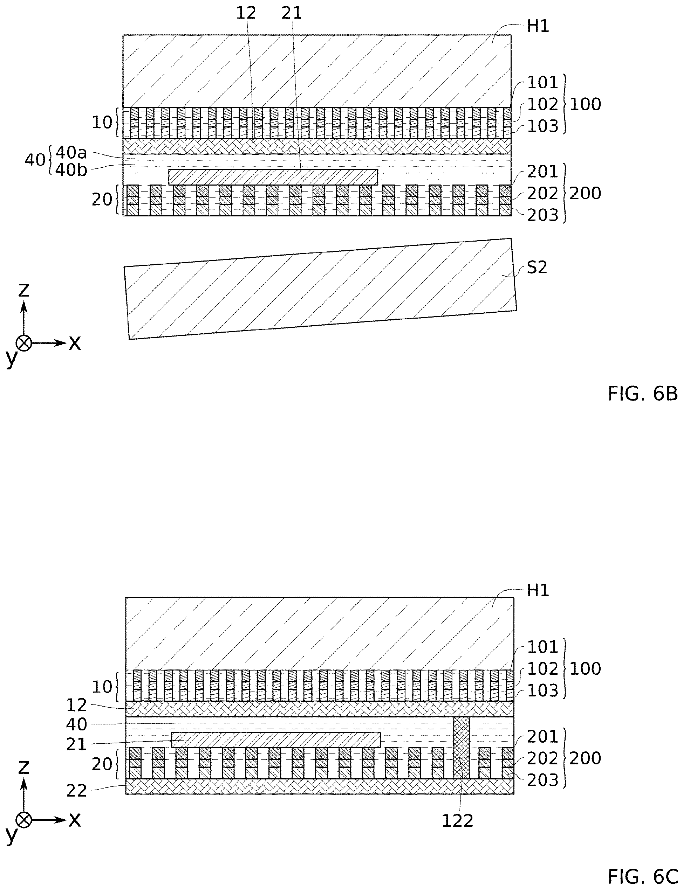

Comme illustré à la figure 6B, les ensembles 10, 20 de nanofils 100, 200 sont ensuite assemblés par collage oxyde-oxyde entre les couches de collage 40a, 40b, par exemple par collage moléculaire. Les couches de collage 40a, 40b déposées pleine plaque permettent une tolérance d'alignement entre les ensembles 10, 20 de nanofils 100, 200. Les couches de collage 40a, 40b forment avantageusement la couche intercalaire diélectrique 40. Le substrat S2 est ensuite retiré.

Comme illustré à la figure 6C, la deuxième couche de contact électrique inférieure 22 à base d'oxyde conducteur transparent est formée de préférence pleine plaque au niveau des régions d'injection de trous 203. Une couche d'oxyde de faible épaisseur (non illustrée) peut être formée sur la deuxième couche de contact électrique inférieure 22 de manière à faciliter le collage ultérieur. Un ou des vias 122 peuvent être formés au travers de l'ensemble 20 de nanofils 200 de manière à connecter électriquement la deuxième couche de contact électrique inférieure 22 à la première couche de contact électrique inférieure 12.

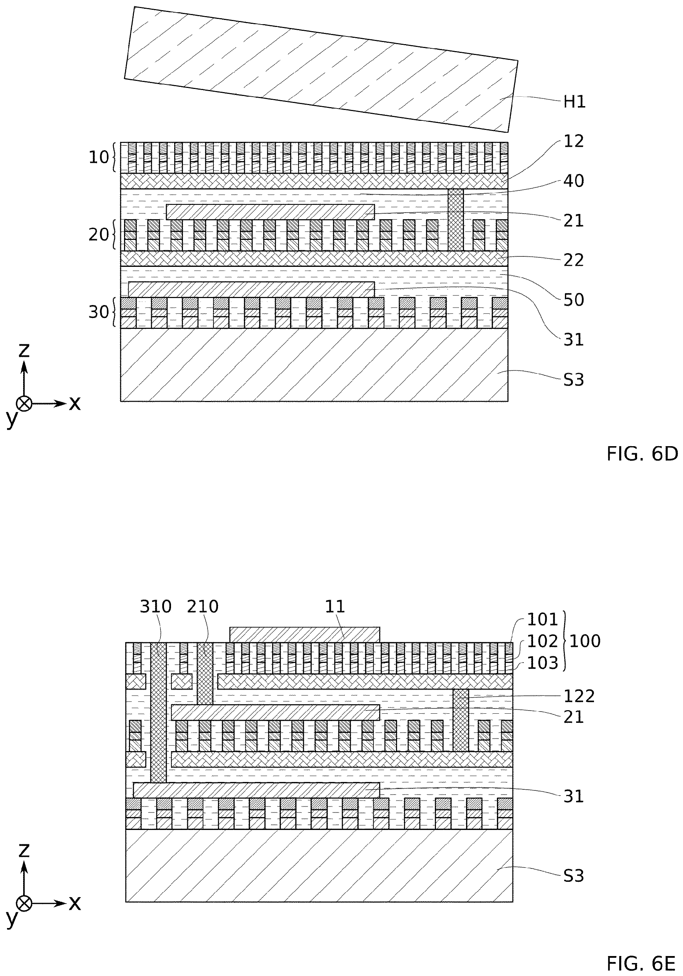

Comme illustré à la figure 6D, les ensembles 20, 30 de nanofils 200, 300 sont ensuite assemblés par collage oxyde-oxyde entre les couches 22, 50. Le substrat de manipulation H1 est ensuite retiré.

Comme illustré à la figure 6E, après retrait du substrat de manipulation H1, la première couche de contact électrique supérieure 11 à base d'oxyde conducteur transparent est formée au niveau des régions d'injection d'électrons 101. Les différentes couches de contact électrique supérieures 11, 21, 31 sont sensiblement à l'aplomb les unes des autres, alignées les unes par rapport aux autres par exemple au niveau d'une de leurs extrémités latérales. Des vias 210, 310 sont typiquement formés au travers des premier et deuxième ensembles 10, 20 de nanofils 100, 200 pour venir connecter respectivement les couches de contact électrique supérieures 21, 31.

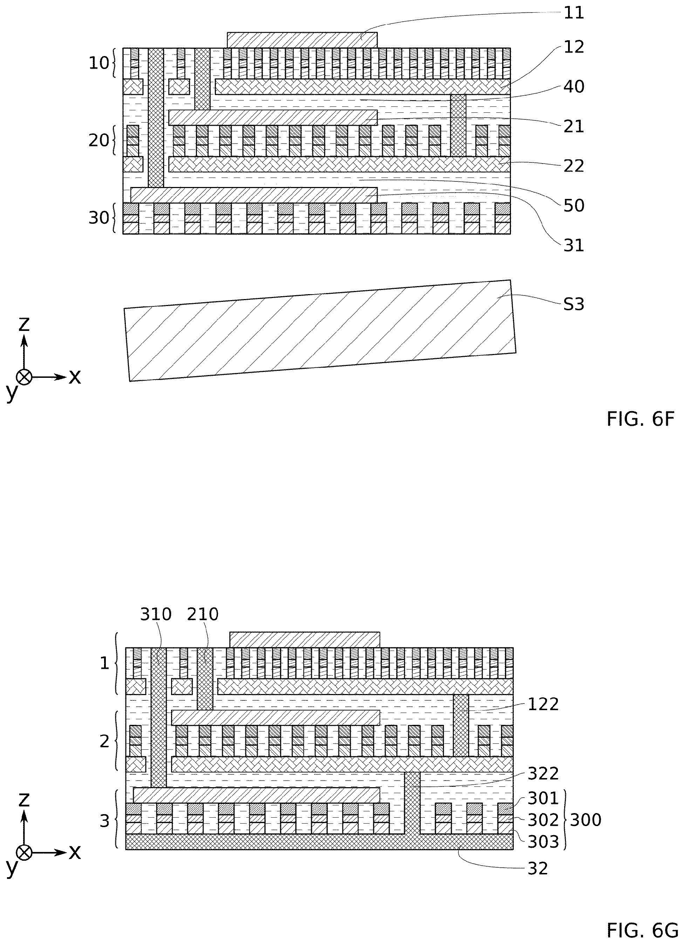

Comme illustré à la figure 6F, le substrat S3 peut ensuite être retiré.

Comme illustré à la figure 6G, après retrait du substrat S3, la troisième couche de contact électrique inférieure 32 métallique peut être formée au niveau des régions d'injection de trous 303. Un ou des vias 322 peuvent ensuite être formés au travers de l'ensemble 30 de nanofils 300 de manière à connecter électriquement la troisième couche de contact électrique inférieure 32 à la deuxième couche de contact électrique inférieure 22.

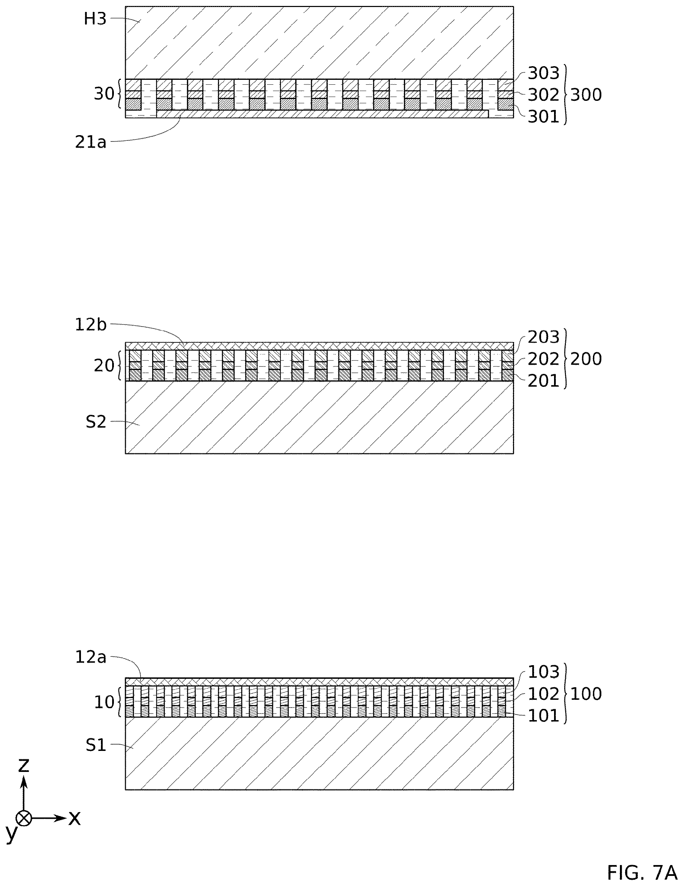

Les figures 7A à 7G illustrent des étapes de fabrication d'un dispositif optoélectronique tel qu'illustré en figure 3, selon un autre mode de réalisation de l'invention.

Comme illustré à la figure 7A, la première étape consiste à former séparément les différents ensembles 10, 20, 30 de nanofils sur des substrats S1, S2, S3 distincts. Les nanofils sont ici de préférence formés avec les régions d'injection d'électrons 101, 102, 103 du côté des substrats S1, S2, S3. De façon similaire aux modes de réalisation décrits précédemment, un substrat de manipulation H3 est assemblé à l'ensemble 30 de nanofils 300 et le substrat S3 est retiré. Une couche de collage 21a à base d'oxyde conducteur transparent est formée au niveau des régions d'injection d'électrons 301. Une couche de collage 12b à base d'oxyde conducteur transparent est formée sur la surface planarisée de l'ensemble 20 de nanofils 200, de préférence pleine plaque, au niveau des régions d'injection de trous 203. Une couche de collage 12a à base d'oxyde conducteur transparent est formée sur la surface planarisée de l'ensemble 10 de nanofils 100, de préférence pleine plaque, au niveau des régions d'injection de trous 103.

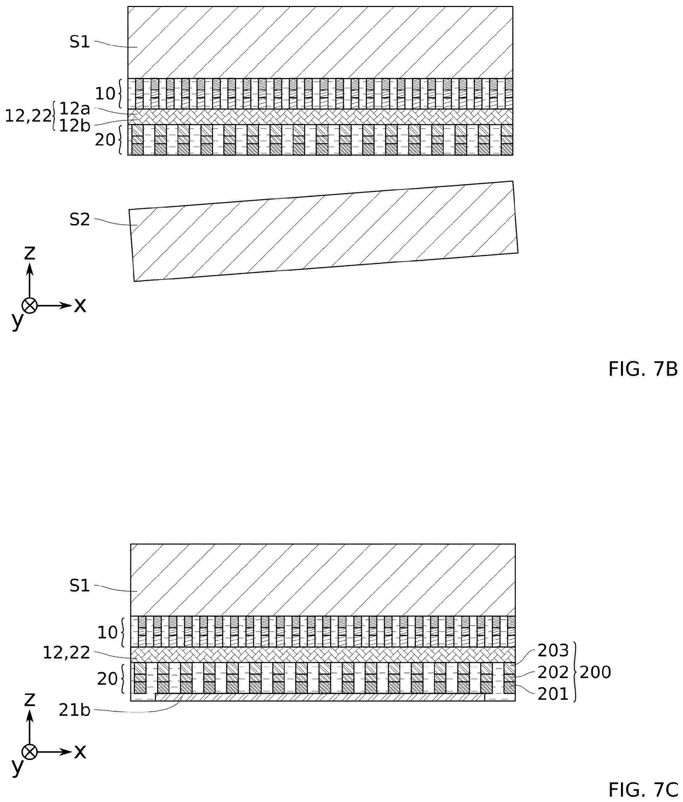

Comme illustré à la figure 7B, les ensembles 10, 20 de nanofils 100, 200 sont ensuite assemblés par collage oxyde-oxyde entre les couches de collage 12a, 12b, par exemple par collage moléculaire. Dans ce mode de réalisation, le substrat S1 portant l'ensemble 10 de nanofils 100 est retourné de façon à mettre en regard les couches de collage 12a, 12b. Les couches de collage 12a, 12b, déposées pleine plaque, permettent une tolérance d'alignement entre les ensembles 10, 20 de nanofils 100, 200. Dans ce mode de réalisation, les couches de collage 12a, 12b forment avantageusement à la fois la première couche de contact électrique inférieure 12 et la deuxième couche de contact électrique inférieure 22. Le substrat S2 est ensuite retiré.

Comme illustré à la figure 7C, une couche de collage 21b à base d'oxyde conducteur transparent est formée au niveau des régions d'injection d'électrons 201.

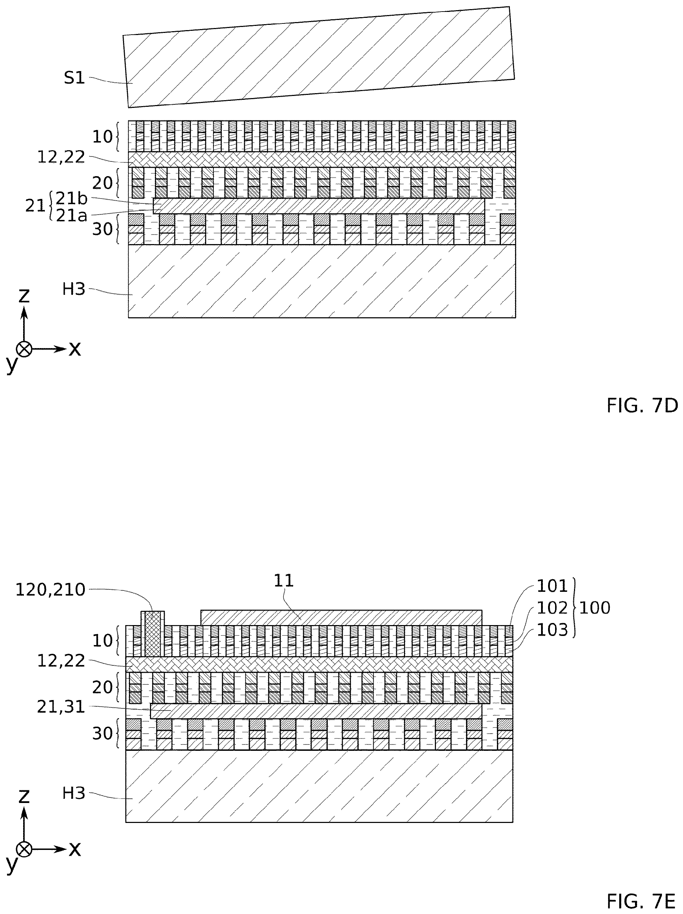

Comme illustré à la figure 7D, les ensembles 20, 30 de nanofils 200, 300 sont ensuite assemblés par collage oxyde-oxyde entre les couches 21a, 21b, par exemple par collage moléculaire. Dans ce mode de réalisation, le substrat de manipulation H3 portant l'ensemble 30 de nanofils 300 est retourné de façon à mettre en regard les couches de collage 21a, 21b. Un alignement est requis pour assembler les couches 21a, 21b qui présentent des dimensions latérales réduites. Dans ce mode de réalisation, les couches de collage 21a, 21b forment avantageusement à la fois la deuxième couche de contact électrique supérieure 21 et la troisième couche de contact électrique supérieure 31. Le substrat S1 est ensuite retiré.

Comme illustré à la figure 7E, après retrait du substrat S1, la première couche de contact électrique supérieure 11 à base d'oxyde conducteur transparent est formée au niveau des régions d'injection d'électrons 101. Un ou des vias 120, 210 sont typiquement formés au travers du premier ensemble 10 de nanofils 100 pour venir connecter la couche formant les couches de contact électrique inférieures 12, 22.

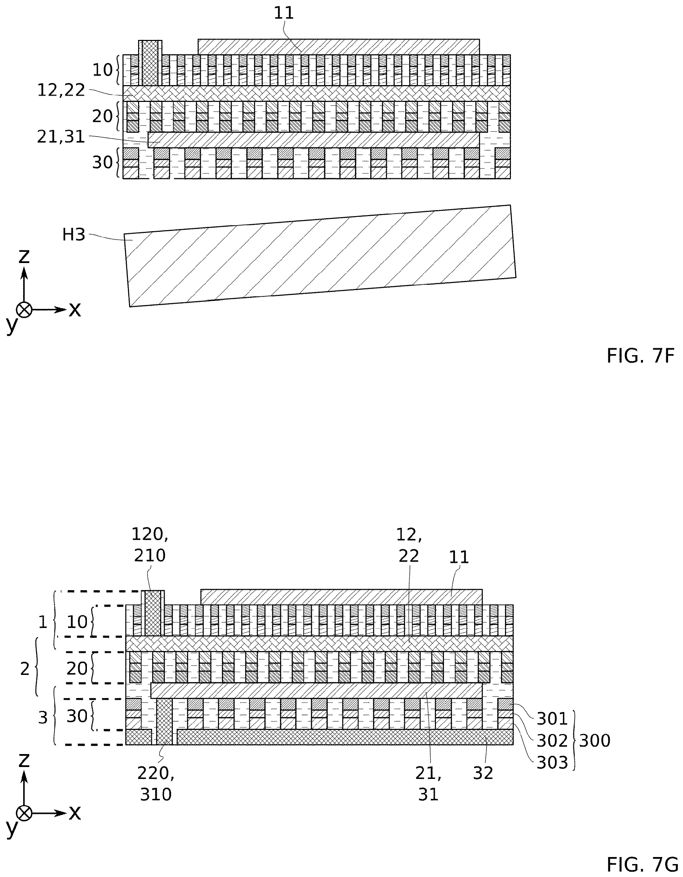

Comme illustré à la figure 7F, le substrat de manipulation H3 est ensuite retiré.

Comme illustré à la figure 7G, après retrait du substrat de manipulation H3, la troisième couche de contact électrique inférieure 32 métallique peut être formée au niveau des régions d'injection de trous 303. Un ou des vias 220, 310 peuvent ensuite être formés au travers de la troisième couche de contact électrique inférieure 32 et de l'ensemble 30 de nanofils 300 de manière à connecter électriquement la couche formant les couches de contact électrique supérieures 21, 31.

Comme illustré au travers des exemples précédents, les dispositifs et procédés selon l'invention permettent donc avantageusement de réaliser des sous-pixels empilés selon une direction principale d'émission du rayonnement lumineux avec une efficacité d'extraction améliorée. Cela permet de réaliser des pixels de dimensions latérales réduites qui peuvent être avantageusement intégrés à des écrans de haute résolution, par exemple pour des applications de réalité augmentée.

L'invention n'est cependant pas limitée aux modes de réalisations précédemment décrits, la portée de l'invention étant définie par les revendications.

## Revendications

1. Dispositif optoélectronique comprenant une pluralité de couches émettrices (1, 2, 3) en empilement selon une direction z, ladite pluralité de couches émettrices (1, 2, 3) comprenant au moins :
• Une première couche émettrice (1) comprenant une première partie active configurée pour émettre un premier rayonnement selon une première longueur d'onde λ1,
• Une deuxième couche émettrice (2) comprenant une deuxième partie active configurée pour émettre un deuxième rayonnement selon une deuxième longueur d'onde λ2 différente de la première longueur d'onde λ1,
lesdites couches émettrices (1, 2, 3) étant au moins en partie superposées en projection selon la direction z,
chaque couche émettrice comprenant en outre, de part et d'autre de la partie active :
• une couche de contact électrique inférieure (12, 22, 32), et
• une couche de contact électrique supérieure (11, 21, 31), ladite couche de contact électrique supérieure étant transparente à la longueur d'onde d'émission λ1, λ2 de la couche émettrice considérée (1, 2, 3),
le dispositif étant **caractérisé en ce que** chacune des couches émettrices (1, 2, 3) comprend un ensemble (10, 20, 30) de nanofils (100, 200, 300) orientés longitudinalement selon la direction z formant la partie active de la couche émettrice (1, 2, 3), lesdits ensembles de nanofils (100, 200, 300) étant structurellement distincts les uns des autres.

2. Dispositif selon la revendication précédente dans lequel les nanofils (100, 200, 300) sont arrangés au sein d'une même couche émettrice (1, 2, 3) de façon à former un cristal photonique.

3. Dispositif selon l'une quelconque des revendications précédentes dans lequel les parties actives des couches émettrices (1, 2, 3) sont disposées en escalier, de sorte que chacun des ensembles (10, 20, 30) de nanofils (100, 200, 300) présentent au moins une partie non couverte par les autres ensembles (10, 20, 30) de nanofils (100, 200, 300).

4. Dispositif selon la revendication précédente dans lequel, pour chaque couche émettrice (1, 2, 3) :
• la couche de contact électrique inférieure (12, 22, 32) est réfléchissante à la longueur d'onde d'émission λ1, λ2 de la couche émettrice considérée (1, 2, 3), et
• la couche de contact électrique supérieure (11, 21, 31) est transparente à la longueur d'onde d'émission λ1, λ2 de la couche émettrice considérée (1, 2, 3),
et dans lequel lesdites couches de contact électrique supérieures transparentes (11, 21, 31) ne sont pas surmontées par les ensembles (10, 20, 30) de nanofils (100, 200, 300).

5. Dispositif selon la revendication 1 dans lequel :
• la couche de contact électrique inférieure (32) située sous toutes les parties actives du dispositif est réfléchissante aux longueurs d'onde d'émission λ1, λ2 desdites parties actives,
• les autres couches de contact électrique inférieures (12, 22) sont transparentes aux longueurs d'onde λ1, λ2 des parties actives situées sous lesdites autres couches de contact électrique inférieures (12, 22),
• les couches de contact électrique supérieures (11, 21, 31) sont transparentes aux longueurs d'onde d'émission λ1, λ2 des parties actives situées sous lesdites couches de contact électrique supérieures (11, 21, 31).

6. Dispositif selon l'une quelconque des revendications précédentes dans lequel toutes les couches de contact électrique inférieures (12, 22, 32) sont reliées entre elles.

7. Dispositif selon la revendication 1 dans lequel deux parties actives adjacentes selon la direction z partagent une même couche de contact électrique transparente, et dans lequel la couche de contact électrique supérieure (31) d'une couche émettrice (3) correspond à la couche de contact électrique supérieure (21) d'une autre couche émettrice (2) située immédiatement au-dessus de ladite couche émettrice (3).

8. Dispositif selon l'une quelconque des revendications précédentes dans lequel certaines au moins des couches de contact électrique inférieures (12, 22, 32) et supérieures (11, 21, 31) sont connectées par des vias (120, 210, 220, 310) traversant selon la direction z au moins un ensemble (10, 20, 30) de nanofils.

9. Dispositif selon l'une quelconque des revendications précédentes dans lequel la pluralité de couches émettrices (1, 2, 3) comprend au moins une troisième couche émettrice (3) comprenant une troisième partie active configurée pour émettre un troisième rayonnement selon une troisième longueur d'onde λ3, avec λ1 ≠ λ2 ≠ λ3, ladite troisième couche émettrice (3) comprenant un troisième ensemble (30) de nanofils (300) orientés longitudinalement selon la direction z et formant ladite troisième partie active.

10. Ecran émissif comprenant une pluralité de pixels formés par des dispositifs optoélectroniques selon l'une quelconque des revendications précédentes, disposés côte à côte dans un plan transverse à la direction z.

11. Procédé de fabrication d'un dispositif optoélectronique selon l'une quelconque des revendications 1 à 9, ledit procédé comprenant au moins les étapes suivantes :
• Former sur un premier substrat (S1) un premier ensemble (10) de nanofils (100) configuré pour émettre le premier rayonnement selon la première longueur d'onde λ1,
• Former une première couche de collage (12a, 40a) pour le premier ensemble (10) de nanofils (100),
• Former sur un deuxième substrat (S2) un deuxième ensemble (20) de nanofils (200) configuré pour émettre le deuxième rayonnement selon la deuxième longueur d'onde λ2, ledit deuxième ensemble (20) de nanofils (200) étant structurellement distinct du premier ensemble (10) de nanofils (100),
• Former une deuxième couche de collage (12b, 40b) pour le deuxième ensemble (20) de nanofils (200),
• Mettre en regard la deuxième couche de collage (12b, 40b) avec la première couche de collage (12a, 40a),
• Assembler les premier et deuxième ensembles (10, 20) de nanofils par collage au niveau des première et deuxième couches de collage (12a, 40a, 12b, 40b),
• Retirer au moins l'un parmi les premier et deuxième substrats (S1, S2),
• Former une première couche de contact électrique inférieure (12) et une première couche de contact électrique supérieure (11) pour le premier ensemble (10) de nanofils (100), ladite première couche de contact électrique supérieure (11) étant transparente à la longueur d'onde d'émission λ1,
• Former une deuxième couche de contact électrique inférieure (22) et une deuxième couche de contact électrique supérieure (21) pour le deuxième ensemble (20) de nanofils (200), ladite deuxième couche de contact électrique supérieure (21) étant transparente à la longueur d'onde d'émission λ2.

12. Procédé selon la revendication précédente dans lequel les première et deuxième couches de collage (12a, 12b) comprennent respectivement des première et deuxième couches métalliques, l'assemblage des premier et deuxième ensembles (10, 20) de nanofils étant effectué par thermocollage desdites première et deuxième couches métalliques (12a, 12b), lesdites première et deuxième couches métalliques formant la première couche de contact électrique inférieure (12), le procédé comprenant en outre, après assemblage et retrait du premier substrat (S1) :
• une gravure d'une partie du premier ensemble (10) de nanofils (100) et des première et deuxième couches de collage (12a, 12b), de façon à exposer une partie du deuxième ensemble (20) de nanofils (200),
• un dépôt d'une couche d'oxyde conductrice transparente sur la partie exposée du deuxième ensemble (20) de nanofils (200), de façon à former la deuxième couche de contact électrique supérieure (21).

13. Procédé selon la revendication précédente comprenant en outre le dépôt d'une couche d'encapsulation (60) transparente sur la couche d'oxyde conductrice transparente (21) au niveau de la partie exposée du deuxième ensemble (20) de nanofils (200).

14. Procédé selon la revendication 11 dans lequel les première et deuxième couches de collage (40a, 40b) comprennent respectivement des première et deuxième couches diélectriques transparentes, l'assemblage des premier et deuxième ensembles (10, 20) de nanofils étant effectué par collage moléculaire desdites première et deuxième couches diélectriques transparentes (40a, 40b), lesdites première et deuxième couches diélectriques transparentes formant une couche diélectrique intercalaire (40) entre la première couche de contact électrique inférieure (12) et la deuxième couche de contact électrique supérieure (21).

15. Procédé selon la revendication 11 dans lequel les première et deuxième couches de collage (12a, 12b) comprennent respectivement des première et deuxième couches d'oxyde conductrices transparentes, l'assemblage des premier et deuxième ensembles (10, 20) de nanofils étant effectué par collage moléculaire desdites première et deuxième couches d'oxyde conductrices transparentes (12a, 12b), lesdites première et deuxième couches d'oxyde conductrices transparentes formant à la fois la première couche de contact électrique inférieure (12) et la deuxième couche de contact électrique inférieure (22).

## Patentansprüche

1. Optoelektronische Vorrichtung, die eine Vielzahl von in einer z-Richtung gestapelten Sendeschichten (1, 2, 3) umfasst, wobei die Vielzahl von Sendeschichten (1, 2, 3) mindestens umfasst:
• eine erste Sendeschicht (1), die einen ersten aktiven Teil umfasst, der so konfiguriert ist, dass er eine erste Strahlung in einer ersten Wellenlänge λ1 sendet,
• eine zweite Sendeschicht (2), die einen zweiten aktiven Teil umfasst, der so konfiguriert ist, dass er eine zweite Strahlung in einer zweiten Wellenlänge λ2 sendet, die sich von der ersten Wellenlänge λ1 unterscheidet,
wobei die Sendeschichten (1, 2, 3) mindestens teilweise in z-Richtung projiziert übereinander liegen,
wobei jede Sendeschicht ferner auf beiden Seiten des aktiven Teils umfasst:
• eine untere elektrische Kontaktschicht (12, 22, 32), und
• eine obere elektrische Kontaktschicht (11, 21, 31), wobei die obere elektrische Kontaktschicht bei der Sendewellenlänge λ1, λ2 der betrachteten Sendeschicht (1, 2, 3) transparent ist,
wobei die Vorrichtung **dadurch gekennzeichnet ist, dass** jede der Sendeschichten (1, 2, 3) eine Anordnung (10, 20, 30) von längs in der z-Richtung ausgerichteten Nanodrähten (100, 200, 300) umfasst, die den aktiven Teil der Sendeschicht (1, 2, 3) bilden, wobei die Anordnung von Nanodrähten (100, 200, 300) strukturell voneinander verschieden sind.

2. Vorrichtung nach vorhergehendem Anspruch, wobei die Nanodrähte (100, 200, 300) innerhalb derselben Sendeschicht (1, 2, 3) so angeordnet sind, dass sie einen Photonenkristall bilden.

3. Vorrichtung nach einem der vorhergehenden Ansprüche, wobei die aktiven Teile der Sendeschichten (1, 2, 3) treppenförmig angeordnet sind, so dass jede der Anordnungen (10, 20, 30) von Nanodrähten (100, 200, 300) mindestens einen Teil aufweist, der nicht von den anderen Anordnungen (10, 20, 30) von Nanodrähten (100, 200, 300) bedeckt ist.

4. Vorrichtung nach vorhergehendem Anspruch, wobei für jede Sendeschicht (1, 2, 3):
• die untere elektrische Kontaktschicht (12, 22, 32) bei der Sendewellenlänge λ1, λ2 der betrachteten Sendeschicht (1, 2, 3) reflektierend ist, und
• die obere elektrische Kontaktschicht (11, 21, 31) bei der Sendewellenlänge λ1, λ2 der betrachteten Sendeschicht (1, 2, 3) transparent ist,
und wobei die oberen transparenten elektrischen Kontaktschichten (11, 21, 31) nicht von den Anordnungen (10, 20, 30) von Nanodrähten (100, 200, 300) überlagert werden.

5. Vorrichtung nach Anspruch 1, wobei:
• die unter allen aktiven Teilen der Vorrichtung befindliche untere elektrische Kontaktschicht (32) bei den Sendewellenlängen λ1, λ2 der aktiven Teile reflektierend ist,
• die anderen unteren elektrischen Kontaktschichten (12, 22) bei den Wellenlängen λ1, λ2 der unter den anderen unteren elektrischen Kontaktschichten (12, 22) befindlichen aktiven Teile transparent sind,
• die oberen elektrischen Kontaktschichten (11, 21, 31) bei den Sendewellenlängen λ1, λ2 der unter den oberen elektrischen Kontaktschichten (11, 21, 31) befindlichen aktiven Teile transparent sind.

6. Vorrichtung nach einem der vorhergehenden Ansprüche, wobei alle unteren elektrischen Kontaktschichten (12, 22, 32) miteinander verbunden sind.

7. Vorrichtung nach Anspruch 1, wobei zwei in z-Richtung benachbarte aktive Teile dieselbe transparente elektrische Kontaktschicht teilen, und wobei die obere elektrische Kontaktschicht (31) einer Sendeschicht (3) der oberen elektrischen Kontaktschicht (21) einer anderen Sendeschicht (2) entspricht, die sich unmittelbar oberhalb der Sendeschicht (3) befindet.

8. Vorrichtung nach einem der vorhergehenden Ansprüche, wobei mindestens einige der unteren (12, 22, 32) und oberen (11, 21, 31) elektrischen Kontaktschichten durch Durchkontaktierungen (120, 210, 220, 310) verbunden sind, die in z-Richtung mindestens eine Nanodrahtanordnung (10, 20, 30) durchqueren.

9. Vorrichtung nach einem der vorhergehenden Ansprüche, wobei die Vielzahl von Sendeschichten (1, 2, 3) mindestens eine dritte Sendeschicht (3) umfasst, die einen dritten aktiven Teil umfasst, der so konfiguriert ist, dass er eine dritte Strahlung in einer dritten Wellenlänge λ3 mit λ1 ≠ λ2 # λ3 sendet, wobei die dritte Sendeschicht (3) eine dritte Anordnung (30) von Nanodrähten (300) umfasst, die in der z-Richtung längs ausgerichtet sind und den dritten aktiven Teil bilden.

10. Emittierender Bildschirm, der eine Vielzahl von Pixeln umfasst, die von optoelektronischen Vorrichtungen nach einem der vorhergehenden Ansprüche gebildet sind, die nebeneinander in einer Ebene quer zu der z-Richtung angeordnet sind.

11. Verfahren zur Herstellung einer optoelektronischen Vorrichtung nach einem der Ansprüche 1 bis 9, wobei das Verfahren mindestens die folgenden Schritte umfasst:
• Bilden, auf einem ersten Substrat (S1), einer ersten Anordnung (10) von Nanodrähten (100), die so konfiguriert ist, dass sie die erste Strahlung in der ersten Wellenlänge λ1 sendet,
• Bilden einer ersten Klebeschicht (12a, 40a) für die erste Anordnung (10) von Nanodrähten (100),
• Bilden, auf einem zweiten Substrat (S2), einer zweiten Anordnung (20) von Nanodrähten (200), die so konfiguriert ist, dass sie die zweite Strahlung in der zweiten Wellenlänge λ2 sendet, wobei die zweite Anordnung (20) von Nanodrähten (200) strukturell von der ersten Anordnung (10) von Nanodrähten (100) verschieden ist,
• Bilden einer zweiten Klebeschicht (12b, 40b) für die zweite Anordnung (20) von Nanodrähten (200),
• Gegenüberstellen der zweiten Klebeschicht (12b, 40b) mit der ersten Klebeschicht (12a, 40a),
• Verbinden der ersten und zweiten Nanodrahtanordnung (10, 20) durch Kleben im Bereich der ersten und zweiten Klebeschicht (12a, 40a, 12b, 40b),
• Entfernen mindestens eines von dem ersten und zweiten Substrat (S1, S2),
• Bilden einer ersten unteren elektrischen Kontaktschicht (12) und einer ersten oberen elektrischen Kontaktschicht (11) für die erste Anordnung (10) von Nanodrähten (100), wobei die erste obere elektrische Kontaktschicht (11) bei der Sendewellenlänge λ1 transparent ist,
• Bilden einer zweiten unteren elektrischen Kontaktschicht (22) und einer zweiten oberen elektrischen Kontaktschicht (21) für die zweite Anordnung (20) von Nanodrähten (200), wobei die zweite obere elektrische Kontaktschicht (21) bei der Sendewellenlänge λ2 transparent ist.

12. Verfahren nach vorhergehendem Anspruch, wobei die erste und zweite Klebeschicht (12a, 12b) jeweils eine erste und zweite Metallschicht umfassen, wobei das Verbinden der ersten und zweiten Nanodrahtanordnung (10, 20) durch Thermoverkleben der ersten und zweiten Metallschicht (12a, 12b) erfolgt, wobei die erste und zweite Metallschicht die erste untere elektrische Kontaktschicht (12) bilden, wobei das Verfahren nach Verbinden und Entfernen des ersten Substrats (S1) ferner umfasst:
• Ätzen eines Teils der ersten Anordnung (10) von Nanodrähten (100) und der ersten und zweiten Klebeschicht (12a, 12b), so dass ein Teil der zweiten Anordnung (20) von Nanodrähten (200) freigelegt wird,
• Aufbringen einer transparenten leitenden Oxidschicht auf den freiliegenden Teil der zweiten Anordnung (20) von Nanodrähten (200), so dass die zweite obere elektrische Kontaktschicht (21) gebildet wird.

13. Verfahren nach vorhergehendem Anspruch, das ferner das Aufbringen einer transparenten Kapselungsschicht (60) auf die transparente leitende Oxidschicht (21) im Bereich des freiliegenden Teils der zweiten Anordnung (20) von Nanodrähten (200) umfasst.

14. Verfahren nach Anspruch 11, wobei die erste und zweite Klebeschicht (40a, 40b) jeweils eine erste und zweite transparente dielektrische Schicht umfassen, wobei das Verbinden der ersten und zweiten Nanodrahtanordnung (10, 20) durch molekulares Verkleben der ersten und zweiten transparenten dielektrischen Schicht (40a, 40b) erfolgt, wobei die erste und zweite transparente dielektrische Schicht eine dielektrische Zwischenschicht (40) zwischen der ersten unteren elektrischen Kontaktschicht (12) und der zweiten oberen elektrischen Kontaktschicht (21) bilden.

15. Verfahren nach Anspruch 11, wobei die erste und zweite Klebeschicht (12a, 12b) jeweils eine erste und zweite transparente leitende Oxidschicht umfassen, wobei das Verbinden der ersten und zweiten Nanodrahtanordnung (10, 20) durch molekulares Verkleben der ersten und zweiten transparenten leitenden Oxidschicht (12a, 12b) erfolgt, wobei die erste und zweite transparente leitende Oxidschicht sowohl die erste untere elektrische Kontaktschicht (12) als auch die zweite untere elektrische Kontaktschicht (22) bilden.

## Claims

1. An optoelectronic device comprising a plurality of emitting layers (1, 2, 3) stacked along a z-direction, said plurality of emitting layers (1, 2, 3) comprising at least:
• A first emitting layer (1) comprising a first active part configured to emit a first radiation at a first wavelength λ1,
• A second emitting layer (2) comprising a second active part configured to emit a second radiation at a second wavelength λ2 different from the first wavelength λ1,
said emitting layers (1, 2, 3) being at least partially superimposed in a projection along the z-direction,
each emitting layer further comprising, on either side of the active part:
• a lower electrical contact layer (12, 22, 32), and
• an upper electrical contact layer (11, 21, 31), said upper electrical contact layer being transparent at the emission wavelength λ1, λ2 of the emitting layer (1, 2, 3) considered,
the device being **characterised in that** each of the emitting layers (1, 2, 3) comprises a set (10, 20, 30) of nanowires (100, 200, 300) oriented longitudinally according to the z-direction forming the active part of the emitting layer (1, 2, 3), said sets of nanowires (100, 200, 300) being structurally distinct from each other.

2. The device according to the preceding claim, wherein the nanowires (100, 200, 300) are arranged within a same emitting layer (1, 2, 3) so as to form a photonic crystal.

3. The device according to any one of the preceding claims, wherein the active parts of the emitting layers (1, 2, 3) are arranged in a staircase-like fashion, so that each of the sets (10, 20, 30) of nanowires (100, 200, 300) has at least one part not covered with the other sets (10, 20, 30) of nanowires (100, 200, 300).

4. The device according to the preceding claim, wherein, for each emitting layer (1, 2, 3):
• the lower electrical contact layer (12, 22, 32) is reflective at the emission wavelength λ1, λ2 of the emitting layer (1, 2, 3) considered, and
• the upper electrical contact layer (11, 21, 31) is transparent at the emission wavelength λ1, λ2 of the emitting layer (1, 2, 3) considered,
and wherein said transparent upper electrical contact layers (11, 21, 31) are not topped by the sets (10, 20, 30) of nanowires (100, 200, 300).

5. The device according to claim 1, wherein:
• the lower electrical contact layer (32) located under all the active parts of the device is reflective at the emission wavelengths λ1, λ2 of said active parts,
• the other lower electrical contact layers (12, 22) are transparent at the wavelengths λ1, λ2 of the active parts located below said other lower electrical contact layers (12, 22),
• the upper electrical contact layers (11, 21, 31) are transparent at the emission wavelengths λ1, λ2 of the active parts located below said upper electrical contact layers (11, 21, 31).

6. The device according to any one of the preceding claims, wherein all the lower electrical contact layers (12, 22, 32) are connected to each other.

7. The device according to claim 1, wherein two adjacent active parts along the z-direction share a same transparent electrical contact layer, and wherein the upper electrical contact layer (31) of an emitting layer (3) corresponds to the upper electrical contact layer (21) of another emitting layer (2) located immediately above said emitting layer (3).

8. The device according to any one of the preceding claims, wherein at least some of the lower (12, 22, 32) and upper (11, 21, 31) electrical contact layers are connected by vias (120, 210, 220, 310) passing according to the z-direction through at least one set (10, 20, 30) of nanowires.

9. The device according to any one of the preceding claims, wherein the plurality of emitting layers (1, 2, 3) comprises at least one third emitting layer (3) comprising a third active part configured to emit a third radiation at a third wavelength λ3, with λ1 # λ2 # λ3, said third emitting layer (3) comprising a third set (30) of nanowires (300) oriented longitudinally according to the z-direction and forming said third active part.

10. An emitting screen comprising a plurality of pixels formed by optoelectronic devices according to any one of the preceding claims, arranged side by side in a plane transverse to the z-direction.

11. A method for manufacturing an optoelectronic device according to any one of claims 1 to 9, said method comprising at least the following steps of:
• Forming on a first substrate (S1) a first set (10) of nanowires (100) configured to emit the first radiation at the first wavelength λ1,
• Forming a first bonding layer (12a, 40a) for the first set (10) of nanowires (100),
• Forming on a second substrate (S2) a second set (20) of nanowires (200) configured to emit the second radiation at the second wavelength λ2, said second set (20) of nanowires (200) being structurally distinct from the first set (10) of nanowires (100),
• Forming a second bonding layer (12b, 40b) for the second set (20) of nanowires (200),
• Arranging the second bonding layer (12b, 40b) facing the first bonding layer (12a, 40a),
• Assembling the first and second sets (10, 20) of nanowires by bonding at the first and second bonding layers (12a, 40a, 12b, 40b),
• Removing at least one of the first and second substrates (S1, S2),
• Forming a first lower electrical contact layer (12) and a first upper electrical contact layer (11) for the first set (10) of nanowires (100), said first upper electrical contact layer (11) being transparent at the emission wavelength λ1,
• Forming a second lower electrical contact layer (22) and a second upper electrical contact layer (21) for the second set (20) of nanowires (200), said second upper electrical contact layer (21) being transparent at the emission wavelength λ2.

12. The method according to the preceding claim, wherein the first and second bonding layers (12a, 12b) respectively comprise first and second metal layers, assembling the first and second sets (10, 20) of nanowires being performed by thermobonding said first and second metal layers (12a, 12b), said first and second metal layers forming the first lower electrical contact layer (12), the method further comprising, after assembling and removing the first substrate (S1):
• etching a part of the first set (10) of nanowires (100) and the first and second bonding layers (12a, 12b), so as to expose a part of the second set (20) of nanowires (200),
• depositing a transparent conductive oxide layer over the exposed part of the second set (20) of nanowires (200), so as to form the second upper electrical contact layer (21).

13. The method according to the preceding claim, further comprising depositing a transparent encapsulation layer (60) over the transparent conductive oxide layer (21) at the exposed part of the second set (20) of nanowires (200).

14. The method according to claim 11, wherein the first and second bonding layers (40a, 40b) comprise first and second transparent dielectric layers respectively, assembling the first and second sets (10, 20) of nanowires being performed by molecular bonding of said first and second transparent dielectric layers (40a, 40b), said first and second transparent dielectric layers forming an interlayer dielectric layer (40) between the first lower electrical contact layer (12) and the second upper electrical contact layer (21).

15. The method according to claim 11, wherein the first and second bonding layers (12a, 12b) respectively comprise first and second transparent conductive oxide layers, assembling the first and second sets (10, 20) of nanowires being performed by molecular bonding of said first and second transparent conductive oxide layers (12a, 12b), said first and second transparent conductive oxide layers forming both the first lower electrical contact layer (12) and the second lower electrical contact layer (22).
